# EUROPEAN PATENT APPLICATION

(11) **EP 4 718 316 A1**
(43) Date of publication of application: **01.04.2026**
(21) Application number: 24811413.4
(22) Date of filing: 23.05.2024
(51) Int. Cl.: G06K 19/077, H05K 1/18

(54) **SMART IC SUBSTRATE, SMART IC MODULE, AND IC CARD COMPRISING SAME**

(30) Priority: 23.05.2023 KR 20230066596
(71) Applicant: LG INNOTEK CO. LTD, Gangseo-gu Seoul 07796 (KR)
(72) Inventor: OH, Jung Hun, Seoul 07796 (KR); LEE, Seung Jin, Seoul 07796 (KR); HYEON, Jeong Min, Seoul 07796 (KR)
(74) Representative: DREISS Patentanwälte PartG mbB
(86) International application number: PCT/KR2024/006974
(87) International publication number: WO 2024/242475

(57) **Abstract**

A smart IC substrate according to an embodiment includes a substrate including a first surface and a second surface opposite the first surface, and having first and second holes passing through the first surface and the second surface and spaced apart from each other in a horizontal direction; a bonding layer disposed on the first surface; a metal layer disposed on the bonding layer; a first plating layer disposed on one surface of the metal layer; a second plating layer and a third plating layer disposed on another surface of the metal layer, wherein the second plating layer overlaps the first hole, the third plating layer overlaps the second hole, and the third plating layer has a thickness greater than that of the second plating layer.

## Description

### [Technical Field]

An embodiment relates to a smart IC substrate, a smart IC module, and an IC card including the same.

### [Background Art]

An IC card is a plastic card with an integrated circuit chip capable of storing and processing information. The IC card is equipped with an IC that stores necessary information and transmits the information to a reader in a form of an electrical signal.

The IC card is manufactured by inserting a smart IC module into a card body.

The smart IC module is classified as a single type or a dual type depending on the arrangement of the metal layers. The single type has a metal layer and a plating layer disposed on only one surface of the substrate. The dual type has the metal layer and plating layer disposed on both surfaces of the substrate.

In addition, the above smart IC modules are classified into contact, contactless, hybrid, and combi cards depending on how the card is used. The contact card transmits and receives information through physical contact. The contactless card transmits and receives information without physical contact. In addition, hybrid cards and combination cards include both contact and contactless functions.

Accordingly, the smart IC module includes a contact surface and a bonding surface. The contact surface contacts an external device, and a chip is disposed on the bonding surface. The bonding surface is inserted into the card body.

The chip disposed on the bonding surface and a conductive pattern disposed on the contact surface are electrically connected by wire bonding. Accordingly, the smart IC module includes a plurality of holes. The chip and the conductive pattern are wire bonded through the holes.

To facilitate the wire bonding, the conductive pattern includes a pad part. The pad part is formed by a plating layer. The plating layer contains gold. To improve the efficiency of the plating process, immersion plating may be performed. Consequently, a plating layer is formed in regions other than the pad part.

Therefore, a plating layer is formed even in regions where a plating layer is not required. Accordingly, process efficiency may be reduced. In addition, since the plating layer includes gold, process cost may be increased.

Therefore, a new structure of a smart IC substrate, a smart IC module, and an IC card including the same that can solve the above problems is required.

A prior art related to the smart IC substrate is disclosed in Korean Patent Publication No. KR10-2022-0110247.

### [Disclosure]

### [Technical Problem]

An embodiment provides a smart IC substrate with improved process efficiency.

### [Technical Solution]

A smart IC substrate according to an embodiment includes a substrate including a first surface and a second surface opposite the first surface, and having first and second holes passing through the first surface and the second surface and spaced apart from each other in a horizontal direction; a bonding layer disposed on the first surface; a metal layer disposed on the bonding layer; a first plating layer disposed on one surface of the metal layer; a second plating layer and a third plating layer disposed on another surface of the metal layer, wherein the second plating layer overlaps the first hole, the third plating layer overlaps the second hole, and the third plating layer has a thickness greater than that of the second plating layer.

In addition, the first plating layer includes a first-first layer and a first-second layer on the first-first layer, the second plating layer includes a second-first layer and a second-second layer on the second-first layer, the third plating layer includes a third-first layer and a third-second layer on the third-first layer, and the third-second layer has a thickness greater than that of the second-second layer.

In addition, thicknesses of the second plating layer and the third plating layer are greater than that of the first plating layer.

In addition, thicknesses of the second-first layer and the third-first layer are greater than that of the first-first layer.

In addition, the third-second layer includes a third-second-a layer and a third-second-b layer on the third-second-a layer, and the third-second-b layer has a thickness greater than that of the third-second-a layer.

In addition, the third-second layer includes a third-second-a layer, a third-second-b layer on the third-second-a layer, and a third-second-c layer on the third-second-b layer, and any one of the third-second-a layer, the third-second-b layer, and the third-second-c layer includes a material different from that of the other layers.

In addition, the third-second-b layer has a thickness greater than that of the third-second-a layer and the third-second-c layer, the third-second-a layer and the third-second-c layer include gold, and the third-second-b layer include silver.

Meanwhile, a smart IC substrate according to an embodiment comprises a substrate including a plurality of holes, and a first surface and a second surface opposite the first surface; a first bonding layer disposed on the first surface; a second bonding layer disposed on the second surface; a first metal layer disposed on the first bonding layer; a second metal layer disposed on the second bonding layer; a first plating layer disposed on one surface of the first metal layer; a third plating layer disposed on another surface of the first metal layer; and a fourth plating layer disposed on one surface of the second metal layer, wherein the fourth plating layer includes a fourth-first plating layer and a fourth-second plating layer, the third plating layer overlaps the hole, the fourth-first plating layer is disposed outside a molding region, the fourth-second plating layer is disposed inside the molding region, and a thickness of the fourth-second plating layer is greater than a thickness of the fourth-first plating layer.

In addition, the third plating layer and the fourth-second plating layer have thicknesses greater than those of the first plating layer,

In addition, the first plating layer includes a first-first layer and a first-second layer on the first-first layer, the third plating layer includes a third-first layer and a third-second layer on the third-first layer, the fourth-first plating layer includes a fourth-first-a layer and a fourth-first-b layer on the fourth-first-a layer, the fourth-second plating layer includes a fourth-second-a layer and a fourth-second-b layer on the fourth-second-a layer, and the fourth-second-b layer has a thickness greater than that of the fourth-first-b layer.

In addition, a thickness of the fourth-first-a layer is greater than a thickness of the first-first layer, and a thickness of the fourth-second-b layer is greater than a thickness of the first-second layer.

In addition, the hole includes a first hole and a second hole, and the smart IC substrate further includes a second plating layer disposed on another surface of the metal layer, and the second plating layer overlaps the first hole,

The third plating layer overlaps the second hole, and a thickness of the third plating layer is greater than a thickness of the second plating layer.

In addition, thicknesses of the second plating layer and the third plating layer are greater than the thickness of the first plating layer.

### [Advantageous Effects]

A smart IC substrate according to an embodiment includes a plurality of plating layers.

The plating layers may include a first plating layer, a second plating layer, and a third plating layer.

The first plating layer and the second plating layer are not connected to a chip. The third plating layer is connected to the chip. Specifically, the third plating layer is wire-bonded to the chip.

The third plating layer has a different thickness from the second plating layer. Specifically, a thickness of the third plating layer is greater than a thickness of the second plating layer.

A thickness of the third plating layer is different from thicknesses of the first plating layer and the second plating layer. Specifically, the third plating layer has a greater thickness than the first plating layer and the second plating layer.

The second plating layer and the third plating layer are disposed on a same surface of a metal layer. The second plating layer and the third plating layer include a nickel layer and a gold layer. The second plating layer and the third plating layer may have different thicknesses of the gold layer. Specifically, a gold layer of the third plating layer, which is wire-bonded to the chip, is formed thick. Furthermore, the gold layer of the second plating layer, which is not connected to the chip, is formed thin.

Therefore, the efficiency of the plating process can be improved. Furthermore, since the gold layer of the second plating layer is thin, the process cost is reduced.

The plating layer may include a first plating layer, a third plating layer, and a fourth plating layer. Alternatively, the plating layer may include a first plating layer, a second plating layer, a third plating layer, and a fourth plating layer.

The fourth plating layer is connected to an external antenna pattern.

The fourth plating layer includes a fourth-first plating layer disposed outside the molding region and a fourth-second plating layer disposed inside the molding region. The fourth-first plating layer and the fourth-second plating layer include a nickel layer and a gold layer. The fourth-first plating layer and the fourth-second plating layer may have different thicknesses of the gold layer. Specifically, the gold layer of the fourth-second plating layer, which is wire-bonded to the chip, is formed thick. Furthermore, the gold layer of the fourth-first plating layer, which is not connected to the chip, is formed thin.

Therefore, the efficiency of the plating process can be improved. Furthermore, since the gold layer of the fourth-first plating layer is thin, process costs are reduced.

Furthermore, the smart IC module according to the embodiment is formed thin. Specifically, the substrate includes a hole. The chip is positioned within the hole. Consequently, a thickness of the smart IC module is reduced.

Therefore, a thickness of a IC card including the smart IC module according to the embodiment can be reduced.

### [Description of Drawings]

FIG. 1 is a top view of a first surface of a smart IC substrate according to a first embodiment.
FIG. 2 is a top view of a second surface of a smart IC substrate according to the first embodiment.
FIGS. 3 to 7 are cross-sectional views taken along region A-A' of FIG. 1.
FIG. 8 is a top view of a second surface of a smart IC module according to a first embodiment.
FIGS. 9 and 10 are cross-sectional views taken along region B-B' of FIG. 8.
FIG. 11 is a top view of a first surface of a smart IC substrate according to a second embodiment.
FIG. 12 is a top view of a second surface of a smart IC substrate according to a second embodiment.
FIG. 13 is a cross-sectional view taken along region C-C' of FIG. 12.
FIGS. 14 and 15 are cross-sectional views taken along region D-D' of FIG. 12.
FIG. 16 is a top view of a second surface of a smart IC module according to a second embodiment.
FIG. 17 is a cross-sectional view taken along region E-E' of FIG. 16.
FIG. 18 is a cross-sectional view taken along region F-F' of FIG. 16.
FIG. 19 is a top view of the first surface of a smart IC substrate according to a third embodiment.
FIG. 20 is a top view of a second surface of a smart IC substrate according to a third embodiment.
FIGS. 21 to 24 are cross-sectional views taken along region G-G' of FIG. 20.
FIG. 25 is a cross-sectional view taken along region H-H' of FIG. 20.
FIG. 26 is a top view of a second surface of a smart IC module according to a third embodiment.
FIG. 27 is a cross-sectional view taken along region I-I' of FIG. 26.
FIG. 28 is a cross-sectional view taken along region J-J' of FIG. 26.
FIG. 29 is an exploded perspective view of a smart IC card according to an embodiment.
FIG. 30 is a drawing illustrating the assembly of a smart IC module according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

Hereinafter, a smart IC substrate, a smart IC module, and a smart IC card including the same according to an embodiment will be described with reference to the drawings.

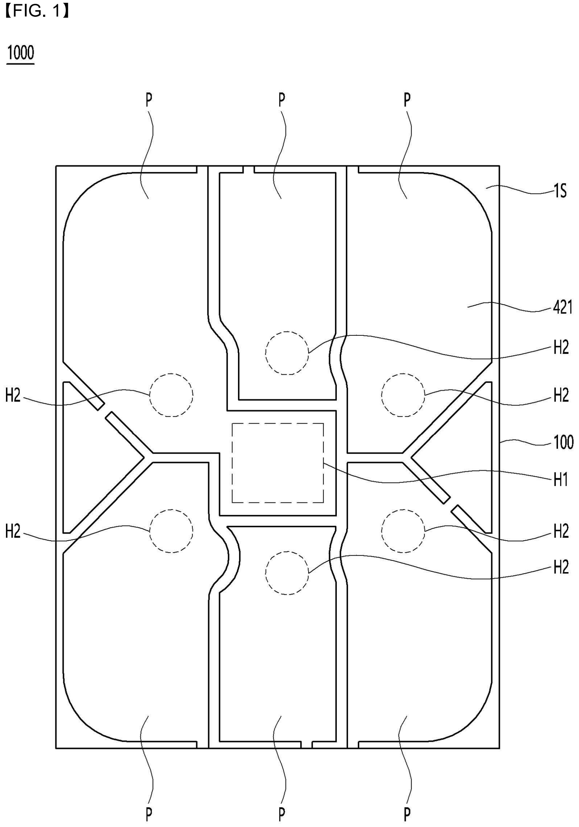

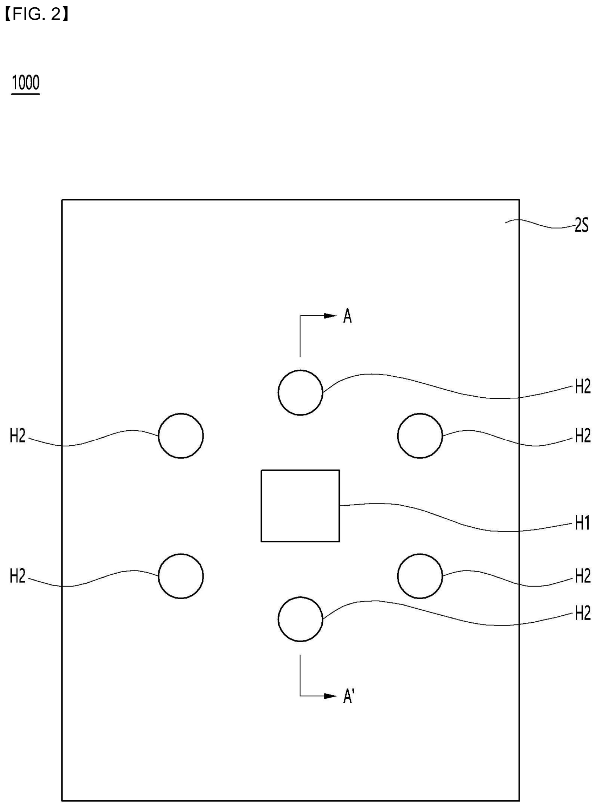

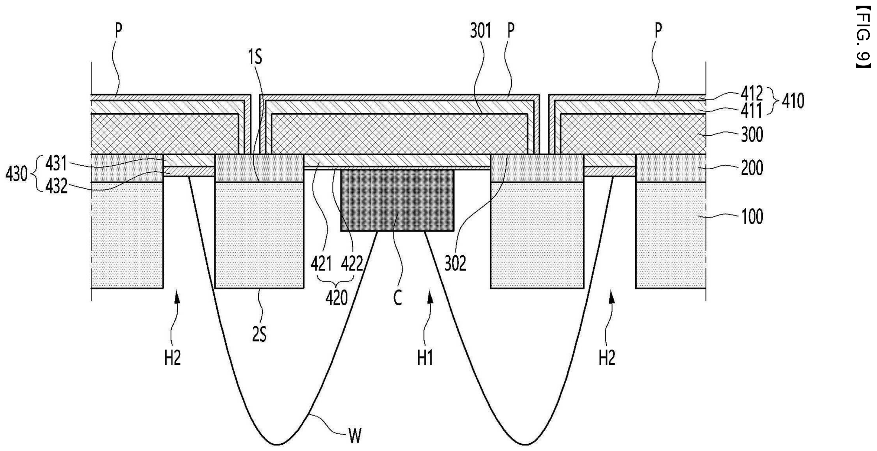

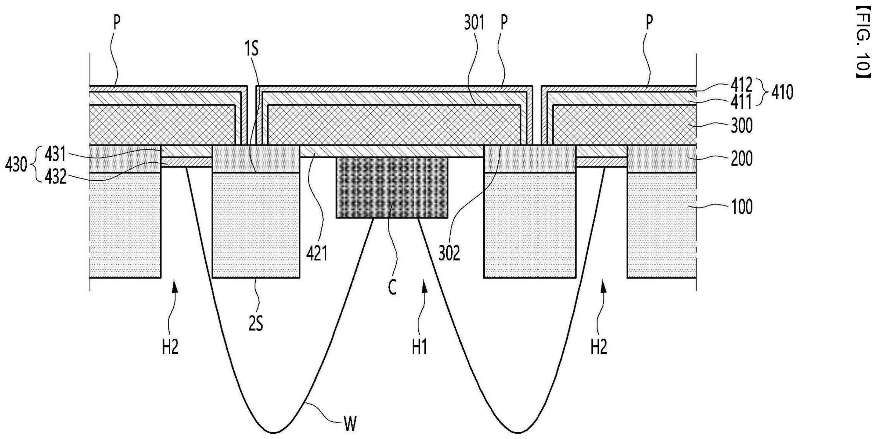

A smart IC substrate 1000 and a smart IC module 2000 according to a first embodiment will be described with reference to FIGS. 1 to 10.

Referring to FIGS. 1 to 7, a smart IC substrate according to a first embodiment includes a substrate 100, a bonding layer 200, a metal layer 300, and a plating layer.

The substrate 100 includes a first surface 1S and a second surface 2S. The first surface 1S and the second surface 2S are opposite surfaces.

The first surface 1S is defined as a contact surface. Specifically, the first surface 1S is a surface capable of recognizing information of the smart IC module through direct or indirect contact. In addition, the second surface 2S is defined as a bonding surface. Specifically, the second surface 2S is a surface on which a chip is mounted and bonded to a body of the smart IC card.

The substrate 100 includes a resin material. The substrate 100 may include a prepreg containing glass fibers. Specifically, the substrate 100 may include a material in which glass fibers and a silicon-based filler (Si filler) are dispersed within an epoxy resin.

Alternatively, the substrate 100 may be rigid or flexible. For example, the substrate 100 may include glass or plastic. Specifically, the substrate 100 may include chemically strengthened/semi-strengthened glass, such as soda lime glass or aluminosilicate glass. Alternatively, the substrate 100 may include polyimide (PI), polyethylene terephthalate (PET), propylene glycol (PPG), polycarbonate (PC), or sapphire.

Alternatively, the substrate 100 may include an optically isotropic film. For example, the substrate 100 may include cyclic olefin copolymer (COC), cyclic olefin polymer (COP), optically isotropic polycarbonate (PC), or optically isotropic polymethyl methacrylate (PMMA).

Alternatively, the substrate 100 may be bent while having a partially curved surface. That is, the substrate 100 may be bent while having a partially flat surface and a partially curved surface. Specifically, an end of the substrate 100 may be bent while having a curved surface. Alternatively, the substrate 100 may be bent while having a random curvature.

The substrate 100 may have a thickness within a set range. For example, the thickness of the substrate 100 may be 80 µm to 150 µm, 90 µm to 140 µm, or 100 µm to 120 µm. If the thickness of the substrate 100 is less than 80 µm, a supporting force of the substrate 100 decreases. In addition, if the thickness of the substrate 100 exceeds 150 µm, the thickness of the smart IC substrate may increase. As a result, the size of the smart IC card is increased.

The substrate 100 has insulating properties. Therefore, the substrate 100 prevents short circuits between circuits. In addition, the substrate 100 serves to support the circuit during a process of forming the circuit.

The substrate 100 includes holes. Specifically, the substrate 100 includes a first hole H1 and a second hole H2.

A size of the first hole H1 is different from a size of the second hole H2. Specifically, the size of the first hole H1 is larger than the size of the second hole H2. A shape of the first hole H1 is different from a shape of the second hole H2. For example, the first hole H2 may be formed in a polygonal shape. In addition, the first hole H1 may be formed in a circular shape. A number of the first holes H1 is different from a number of the second holes H2. Specifically, the number of the first holes H1 is smaller than the number of the second holes H2.

The first hole H1 is a region where a chip C is disposed. The second hole H2 is a region where wire bonding is performed. That is, the chip C disposed within the first hole H1 is wire-bonded to a plating layer through the second hole H2.

The second hole H2 includes a plurality of holes. At least one of the plurality of holes is a wire-bonding region. For example, all of the plurality of holes are wire-bonding regions. Alternatively, some of the plurality of holes are wire-bonding regions.

The second hole H2 has a width within a set range. The width of the second hole H2 may be defined as a diameter of the second hole or a minimum distance between inner surfaces of the second hole. For example, the width of the second hole H2 may be 500 µm to 1,000 µm, 600 µm to 900 µm, or 700 µm to 800 µm. If the width of the second hole H2 is less than 500 µm, wire bonding through the second hole H2 becomes difficult. In addition, if the width of the second hole H2 exceeds 1000 µm, the support force of the substrate 100 decreases.

The bonding layer 200 is disposed on the substrate 100. Specifically, a bonding layer 200 is disposed on the first surface 1S.

The bonding layer 200 includes a resin material. For example, the bonding layer 200 may include at least one of epoxy resin, acrylic resin, and polyimide resin. In addition, the bonding layer 200 may include at least one additive selected from a group consisting of natural rubber, a plasticizer, a curing agent, and a phosphorus-based flame retardant. This enhances the flexibility of the bonding layer 200.

A bonding layer 200 may have a thickness within a set range. For example, the thickness of the bonding layer 200 may range from 15 µm to 35 µm, 20 µm to 30 µm, or 22 µm to 28 µm. If the thickness of the bonding layer 200 is less than 15 µm, the adhesive strength of the bonding layer 200 decreases. This may cause the metal layer to peel off on the bonding layer 200. In addition, if the thickness of the bonding layer 200 exceeds 35 µm, the thickness of the smart IC substrate may increase. As a result, the size of the smart IC card increases.

The smart IC substrate 1000 includes a plurality of conductive patterns P. The conductive patterns P are disposed on the first surface 1S. The conductive patterns P are disposed on the bonding layer 200. The conductive patterns P are disposed on the contact surface.

The conductive patterns P are disposed spaced apart from each other. The second hole H is disposed in a region corresponding to each conductive pattern P.

A metal layer 300 is disposed on the substrate 100. The metal layer 300 is disposed on the bonding layer 200. The metal layer 300 includes a metal material. For example, the metal layer 300 may include at least one material selected from a group consisting of gold (Au), silver (Ag), platinum (Pt), titanium (Ti), tin (Sn), copper (Cu), and zinc (Zn). Preferably, the metal layer 300 includes copper.

The metal layer 300 may have a thickness within a set range. For example, the thickness of the metal layer 300 may be 30 µm to 75 µm, 40 µm to 65 µm, or 50 µm to 60 µm. If the thickness of the metal layer 300 is less than 30 µm, the resistance of the metal layer 300 increases. In addition, if the thickness of the metal layer 300 exceeds 75 µm, the thickness of the smart IC substrate may increase. As a result, a size of the smart IC card is increased. In addition, process efficiency may decrease.

The plating layer is disposed on the metal layer 300. Specifically, the plating layer is disposed on one surface 301 of the metal layer and the other surface 302 opposite the one surface 301.

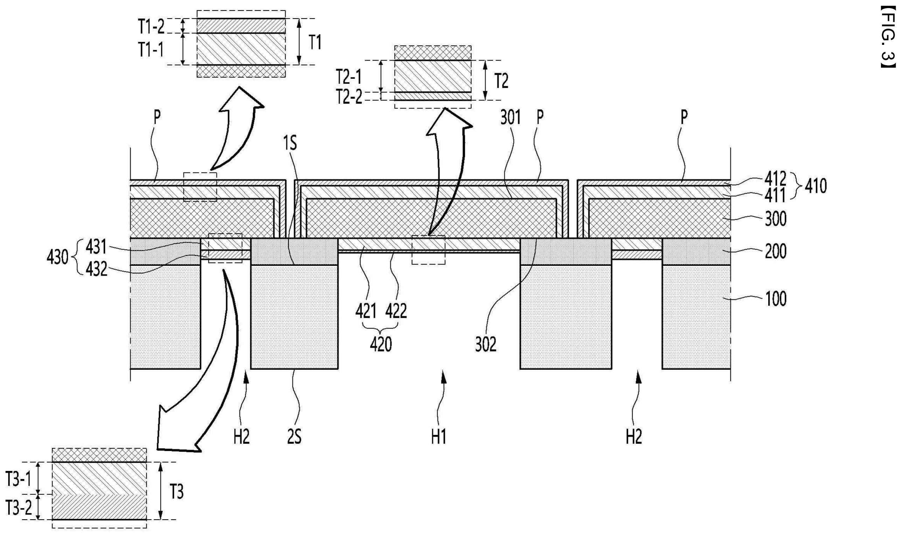

Referring to FIGS. 3 to 6, the plating layer is divided into multiple plating layers depending on their positions. Specifically, the plating layer may include a first plating layer 410, a second plating layer 420, and a third plating layer 430 disposed at different positions.

The first plating layer 410 is disposed on one surface 301 of the metal layer 300. The second plating layer 420 is disposed on the other surface 302 of the metal layer 300. The second plating layer 420 is disposed in a region overlapping the first hole H1. The third plating layer 430 is disposed on the other surface 302 of the metal layer 300. The third plating layer 430 is disposed in a region overlapping the second hole H2.

The first plating layer 410 includes a first-first layer 411 and a first-second layer 412. The first-first layer 411 is disposed in contact with the metal layer 300. The first-second layer 412 is disposed in contact with the first-first layer 411. Accordingly, the first-first layer 411 is disposed between the metal layer 300 and the first-second layer 412.

The second plating layer 420 includes a second-first layer 421 and a second-second layer 422. The second-first layer 421 is disposed in contact with the metal layer 300. The second-second layer 422 is disposed in contact with the second-first layer 421. Accordingly, the second-first layer 421 is disposed between the metal layer 300 and the second-second layer 422.

The third plating layer 430 includes a third-first layer 431 and a third-second layer 432. The third-first layer 431 is disposed in contact with the metal layer 300. The third-second layer 432 is disposed in contact with the third-first layer 431. Accordingly, the third-first layer 431 is disposed between the metal layer 300 and the third-second layer 432.

The first-first layer 411, the second-first layer 421, and the third-first layer 431 may include a same material. Specifically, the first-first layer 411, the second-first layer 421, and the third-first layer 431 may include a same metal. For example, the first-first layer 411, the second-first layer 421, and the third-first layer 431 may include nickel.

The first-second layer 412, the second-second layer 422, and the third-second layer 432 may include a same material. Specifically, the first-second layer 412, the second-second layer 422, and the third-second layer 432 may include a same metal. For example, the first-second layer 412, the second-second layer 422, and the third-second layer 432 may include gold (Au) or palladium (Pd).

The first plating layer 410, the second plating layer 420, and the third plating layer 430 may have different sizes. In detail, a thickness T1 of the first plating layer 410, a thickness T2 of the second plating layer 420, and a thickness T3 of the third plating layer 430 may be different.

The thickness T3 of the third plating layer 430 is greater than the thickness T1 of the first plating layer 410. A thickness T3-1 of the third-first layer 431 and a thickness T1-1 of the first-first layer 411 may be different. In detail, the thickness T3-1 of the third-first layer 431 may be greater than the thickness T1-1 of the first-first layer 411. In addition, a thickness T3-2 of the third-second layer 432 and a thickness T1-2 of the first-second layer 412 are different. In detail, the thickness T3-2 of the third-second layer 432 is greater than the thickness T1-2 of the first-second layer 412. Accordingly, the thickness T3 of the third plating layer 430 is greater than the thickness T1 of the first plating layer 410.

In addition, the thickness T3 of the third plating layer 430 is greater than the thickness T2 of the second plating layer 420. In detail, the thickness T3-1 of the third-first layer 431 and the thickness T2-1 of the second-first layer 421 are the same or similar. In addition, the thickness T3-2 of the third-second layer 432 and the thickness T2-2 of the second-second layer 422 are different. In detail, the thickness T3-2 of the third-second layer 432 is greater than the thickness T2-2 of the second-second layer 422. Accordingly, the thickness T3 of the third plating layer 430 is greater than the thickness T2 of the second plating layer 420.

Furthermore, the thickness T2 of the second plating layer 420 is greater than the thickness T1 of the first plating layer 410. The thickness T2-1 of the second-first layer 421 and the thickness T1-1 of the first-first layer 411 may be different. In detail, the thickness T2-1 of the second-first layer 421 may be greater than the thickness T1-1 of the first-first layer 411. In addition, the thickness T1-2 of the first-second layer 412 and the thickness T2-2 of the second-second layer 422 are the same or similar. Accordingly, the thickness T2 of the second plating layer 420 is greater than the thickness T1 of the first plating layer 410.

The thickness T1-1 of the first-first layer 411 may be 1 µm to 3 µm. In addition, the thickness T2-1 of the second-first layer 421 and the thickness T3-1 of the third-first layer 431 may be 2 µm to 9 µm. The thickness T2-1 of the second-first layer 421 and the thickness T3-1 of the third-first layer 431 are greater than the thickness T1-1 of the first-first layer 411 within the above range.

The third plating layer 430 is a layer bonded to a wire connected to the chip C. For this purpose, the third-second layer 432 is disposed thicker than the first-second layer 412. Therefore, since the third-first layer 431 must support the third-second layer 432, the thickness T3-1 of the third-first layer 431 is greater than the thickness T1-1 of the first-first layer 411 within the above range.

In addition, the second-first layer 421 and the third-first layer 431 may be formed by a same plating process for process efficiency. Therefore, the thickness T2-1 of the second-first layer 421 may be the same as or similar to the thickness T3-1 of the third-first layer 431.

The thickness T1-2 of the first-second layer 412 may be 0.01 µm to 0.1 µm. The first plating layer 410 is disposed on the first surface 1S of the substrate 100. Therefore, the first plating layer 410 may be exposed to an outside of the smart IC card. Since the first-first layer 411 contains nickel, the first-first layer 411 has toxicity that is harmful to the human body. Therefore, the first-second layer 421 is disposed on the first-first layer 411. Accordingly, the first-first layer 411 is prevented from being exposed to the outside. In addition, the first-second layer 422 contains gold. Therefore, the aesthetics of an external user is improved.

The thickness T3-2 of the third-second layer 432 may be 0.2 µm to 0.8 µm, 0.2 µm to 0.7 µm, or 0.2 µm to 0.5 µm. The third plating layer 430 is bonded to a wire connected to the chip C. Therefore, the thickness T3-2 of the third-second layer 432 is formed to be greater than the thicknesses of the first-second layer 412 and the second-second layer 422. If the thickness T3-2 of the third-second layer 432 is less than 0.2 µm, the wire is not stably bonded. In addition, if the thickness T3-2 of the third-second layer 432 exceeds 0.8 µm, the process cost increases and the process efficiency decreases.

The thickness T2-2 of the second-second layer 422 may be 0.003 µm to 0.05 µm. The second plating layer 420 is not bonded to the wire. The chip C is disposed on the second-second layer 422. Therefore, the second-second layer 422 need not be formed as thick as the third-second layer 432. Accordingly, the thickness T2-2 of the second-second layer 422 is smaller than the thickness T3-2 of the third-second layer 432.

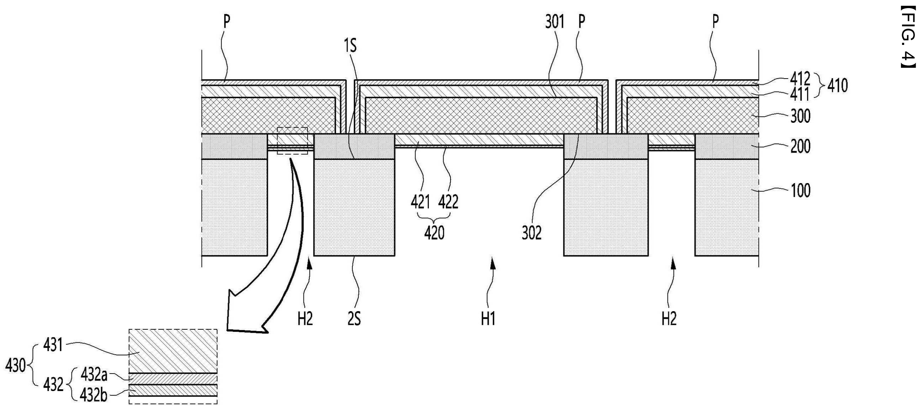

Referring to FIG. 4, the third-second layer 432 may include multiple layers. The third-second layer 432 may include a third-second-a layer 432a and a third-second-b layer 432b. The third-second-a layer 432a is disposed on the third-first layer 431. The third-second-a layer 432a is in contact with the third-first layer 431. The third-second-b layer 432b is disposed on the third-second-a layer 432a. The third-second-b layer 432b is in contact with the third-second-a layer 432a.

The third-second-a layer 432a and the third-second-b layer 432b may include a same material. For example, the third-second-a layer 432a and the third-second-b layer 432b may include gold or palladium.

The third-second-a layer 432a and the third-second-b layer 432b may have different thicknesses. For example, the thickness of the third-second-b layer 432b may be greater than the thickness of the third-second-a layer 432a.

The third-second-a layer 432a is formed by immersion plating. Therefore, as the third-second-a layer 432a is formed, a portion of the first-second layer 412 and the second-second layer 422 are also formed. For example, a portion of the first-second layer 412 is formed to a thickness equivalent to the third-second-a layer 432a, and the second-second layer 422 is formed to a thickness equivalent to the third-second-a layer 432a. That is, the second-second layer 422 is formed simultaneously with a process of forming the third-second-a layer 432a. Accordingly, the thickness of the second-second layer 422 may correspond to the thickness of the third-second-a layer 432a.

Therefore, the process efficiency of the smart IC substrate is improved.

The third-second-b layer 432b is formed by selective plating. Therefore, the third-second-b layer 432b is disposed only in a region overlapping the second hole H2. As described above, the first-second layer 412, the second-second layer 422, and the third-second layer 432 are formed with different thicknesses. Therefore, the third-second-b layer 432b is disposed only in a region overlapping the second hole H2 by selective plating. The first-second layer 412, the second-second layer 422, and the third-second layer 432 may be formed of a same material. The first-second layer 412, the second-second layer 422, and the third-second layer 432 may include gold (Au) or palladium (Pd). The third-second layer 432 may be formed of a different material from the first-second layer 412. The third-second-b layer 432b may include silver (Ag).

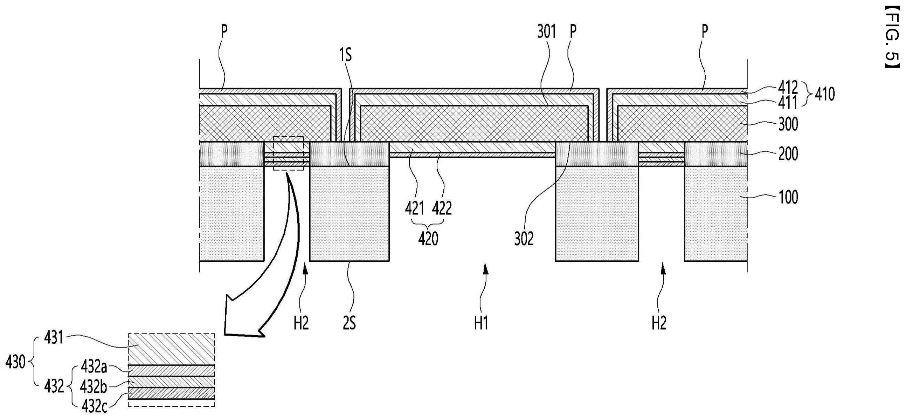

Referring to FIG. 5, the third-second layer 432 may include multiple layers. The third-second layer 432 may include a third-second-a layer 432a, a third-second-b layer 432b, and a third-second-c layer 432c. The third-second-a layer 432a is disposed on the third-first layer 431. The third-second-a layer 432a is in contact with the third-first layer 431. The third-second-b layer 432b is disposed on the third-second-a layer 432a. The third-second-b layer 432b is in contact with the third-second-a layer 432a. The third-second-c layer 432c is disposed on the third-second-b layer 432b. The third-second-c layer 432c is in contact with the third-second-b layer 432b.

The third-second-a layer 432a, the third-second-b layer 432b, and the third-second-c layer 432c may contain different materials. Specifically, any one of the third-second-a layer 432a, the third-second-b layer 432b, and the third-second-c layer 432c may contain a different material from the other layers. For example, the third-second-a layer 432a and the third-second-c layer 432b may include a same material. Specifically, the third-second-a layer 432a and the third-second-c layer 432c may comprise gold or palladium. Furthermore, the third-second-b layer 432b may include a different material from the third-second-a layer 432a and the third-second-c layer 432c. Specifically, the third-second-b layer 432b may include silver (Ag).

The third-second-a layer 432a and the third-second-b layer 432b may have different thicknesses. For example, the thickness of the third-second-b layer 432b may be greater than that of the third-second-a layer 432a.

The third-second-a layer 432a is formed by immersion plating. Therefore, as the third-second-a layer 432a is formed, portions of the first-second layer 412 and the second-second layer 422 are also formed. That is, the first-second layer 412 and the second-second layer 422 are partially formed to the same thickness as the third-second-a layer 432a.

The third-second-b layer 432b and the third-second-c layer 432c are formed by selective plating. Therefore, the third-second-b layer 432b and the third-second-c layer 432c are disposed only in a region overlapping the second hole H2.

The third-second-b layer 432b and the third-second-c layer 432c may have different thicknesses. Specifically, the thickness of the third-second-b layer 432b is greater than that of the third-second-c layer 432c. Accordingly, the thickness of the third plating layer 430 can be formed within a set range by the third-second-b layer 432b. Furthermore, since the third-second-b layer 432b contains silver (Ag), process costs can be reduced. Furthermore, an uppermost surface of the third plating layer 430 is formed by the third-second-c layer 432c containing gold. Therefore, the wire and the third plating layer 430 can be stably bonded.

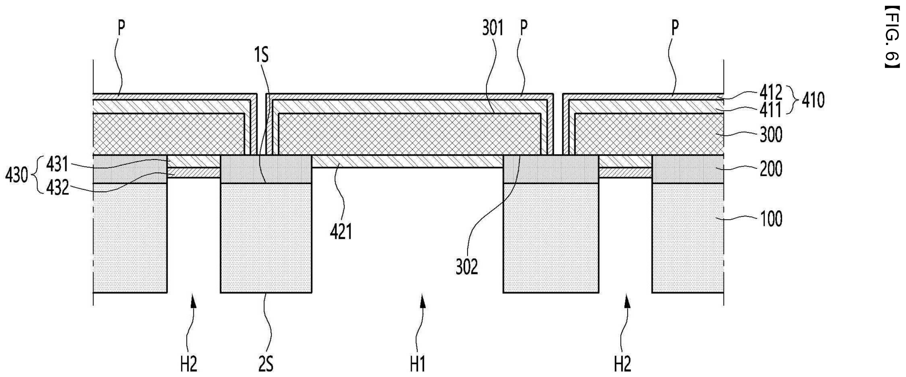

Referring to FIG. 6, the second plating layer 420 may not include the second-second layer 422. That is, the second plating layer 420 may only include the second-first layer 421. For example, the third-second layer 432 may be formed through selective plating. Accordingly, the second-second layer 422 is not formed on the second plating layer 420. Consequently, unnecessary plating processes are omitted, thereby improving process efficiency and reducing material usage.

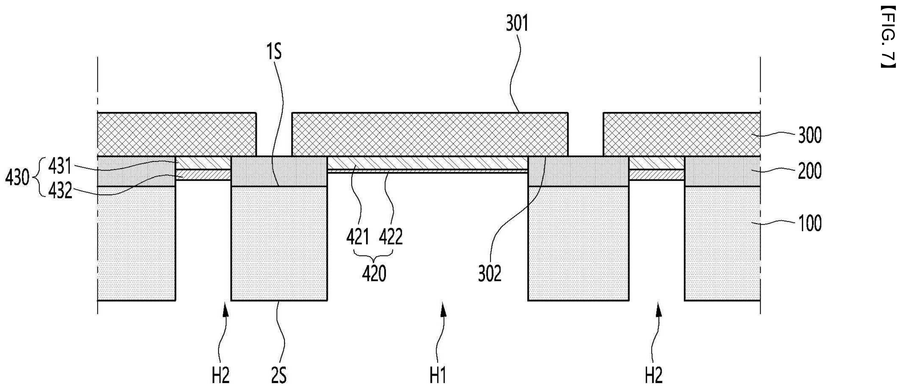

Meanwhile, referring to FIG. 7, the first plating layer 410 may not be formed on one surface 301 of the metal layer 300.

For example, the metal layer 300 may include an alloy. For example, the metal layer 300 may include a nickel (Ni)-chromium (Cr)-iron (Fe) alloy. Accordingly, the corrosion resistance of the metal layer 300 may be improved. Accordingly, corrosion of the metal layer 300 can be prevented even without a separate first plating layer 410 being formed on one surface 301 of the metal layer 300. Therefore, a separate plating layer may not be formed on the contact surface. Furthermore, the thickness of the smart IC substrate can be reduced.

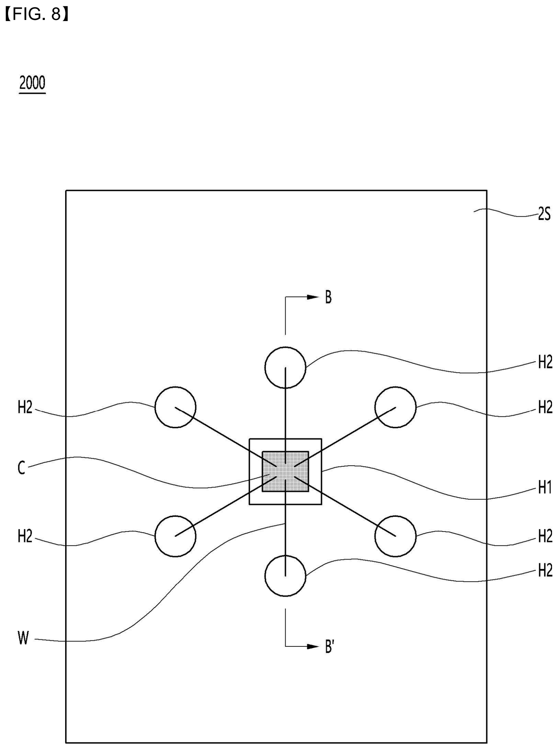

A smart IC module 2000 according to a first embodiment will now be described with reference to FIGS. 8 to 10 . The smart IC module 2000 includes the smart IC substrate 1000 and a chip C according to the first embodiment described above.

The chip C is formed on the other surface 302 of the metal layer 300. The chip C is formed within the first hole H1. Accordingly, the thickness of the smart IC module 2000 can be reduced.

The chip C is connected to the third plating layer 430. Specifically, the chip C and the third plating layer 430 are wire-bonded using a wire W. Accordingly, the chip C and the conductive patterns P are electrically connected.

In the smart IC substrate according to the first embodiment, the chip C is disposed within the first hole H1. This reduces the thickness of the smart IC module.

Furthermore, in the smart IC substrate according to the first embodiment, the second plating layer is formed to a thickness smaller than that of the third plating layer. The second plating layer is not wire-bonded, so the second-second plating layer can be formed to a smaller thickness. Alternatively, the second-second plating layer may be omitted.

Therefore, unnecessary plating processes are omitted, thereby improving process efficiency and reducing process costs.

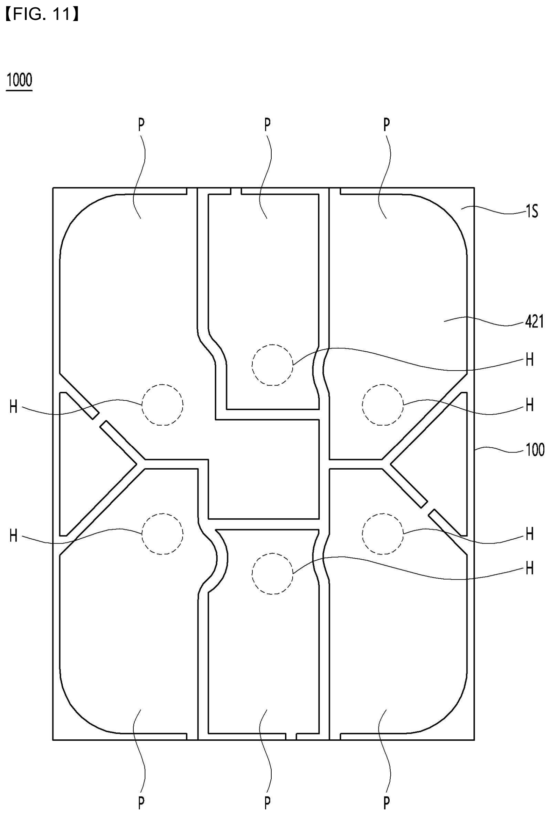

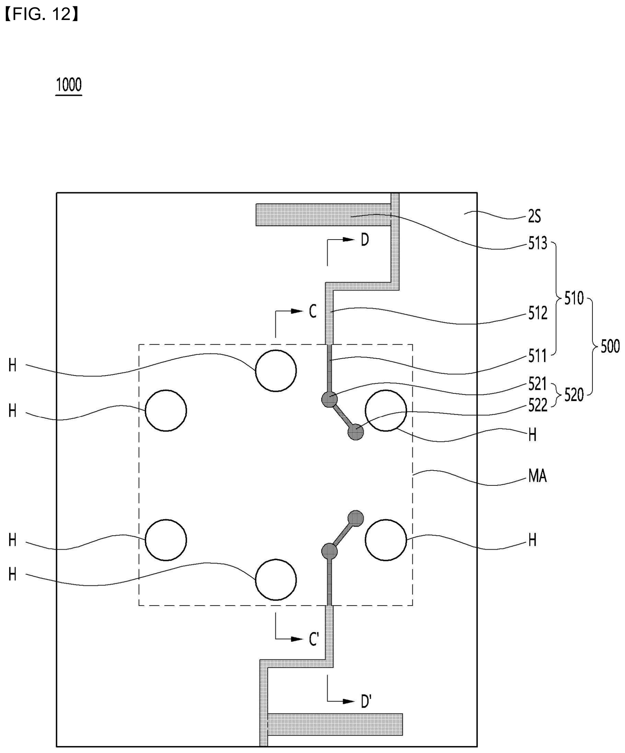

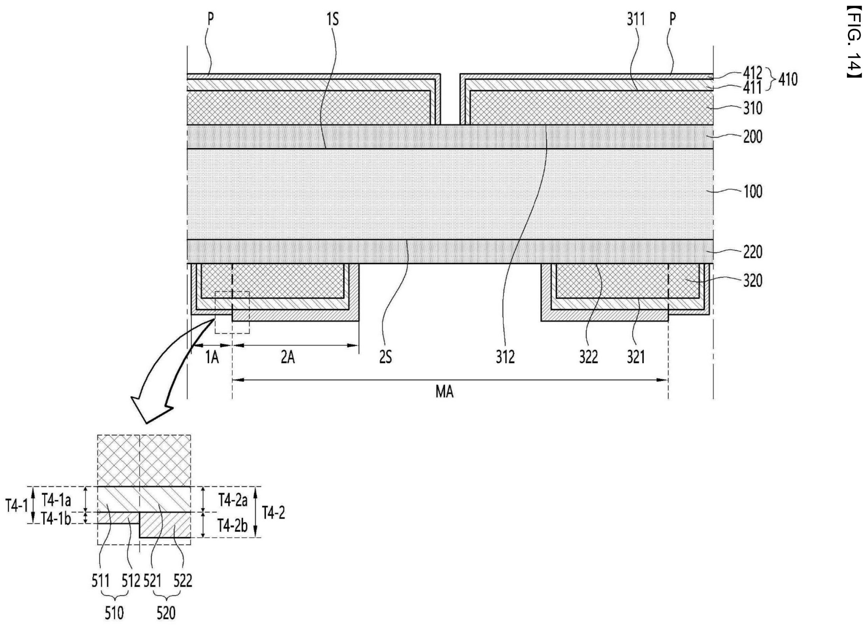

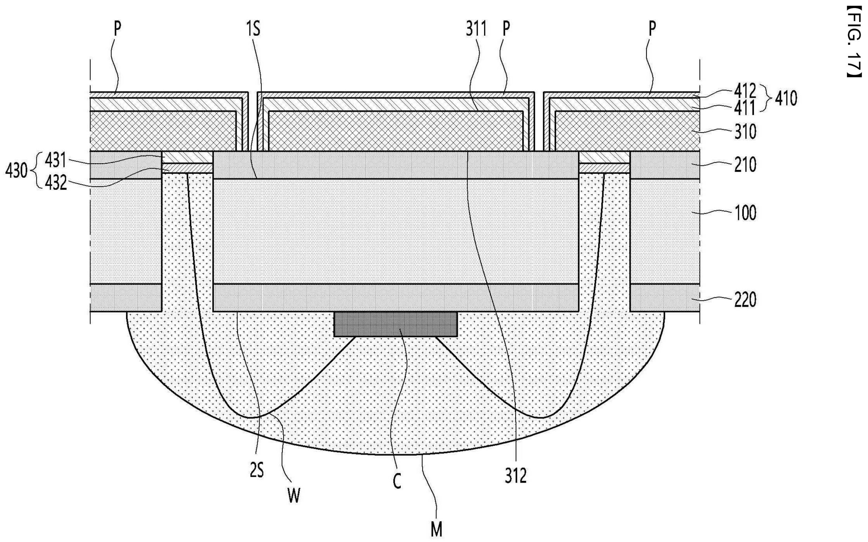

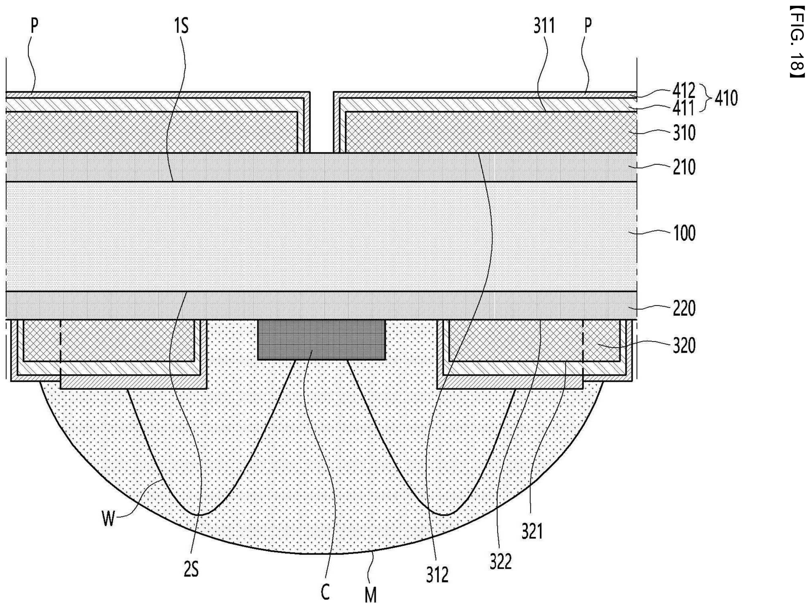

Hereinafter, a smart IC substrate 1000 and a smart IC module 2000 according to a second embodiment will be described with reference to FIGS. 11 to 18. Descriptions of similar or identical elements to those of the first embodiment will be omitted. Also, the same reference numerals are assigned to the same components as in the first embodiment.

Referring to FIGS. 11 to 15, a smart IC substrate according to the second embodiment includes a substrate 100, a bonding layer 200, a metal layer 300, and a plating layer.

The substrate 100 includes a first surface 1S and a second surface 2S. The first surface 1S and the second surface 2S are opposite surfaces. The first surface 1S is defined as a contact surface. In addition, the second surface 2S is defined as a bonding surface.

The material, shape, and thickness of the substrate 100 are the same as in the first embodiment.

The substrate 100 includes a hole H. The hole H includes a plurality of holes. At least one of the plurality of holes is a region where wire bonding is performed. For example, all of the plurality of holes are regions where wire bonding is performed. Alternatively, some of the holes among the plurality of holes are regions for wire bonding. The chip C and the plating layer are wire bonded through the holes H.

The holes H have a width within a set range. The width of the holes H may be defined as the diameter of the holes or the minimum distance between the inner surfaces of the holes. For example, the width of the holes H may be 500 µm to 1,000 µm, 600 µm to 900 µm, or 700 µm to 800 µm. If the width of the holes H is less than 500 µm, wire bonding through the holes H becomes difficult. Furthermore, if the width of the holes H exceeds 1,000 µm, the support force of the substrate 100 decreases.

The bonding layer 200 is disposed on the substrate 100. Specifically, the bonding layer 200 includes a first bonding layer 210 and a second bonding layer 220. The first bonding layer 210 is disposed on the first surface 1S. The second bonding layer 220 is disposed on the second surface 2S.

The material and thickness of the bonding layer 200 are the same as those of the first embodiment.

The smart IC substrate 1000 includes a plurality of conductive patterns P and a wiring pattern 500. The conductive patterns P are disposed on the first surface 1S. The conductive patterns P are disposed on the first bonding layer 210. The conductive patterns P are disposed on the contact surface.

The conductive patterns P are spaced apart from each other. The holes H are disposed in regions corresponding to each conductive pattern P.

The wiring pattern 500 is disposed on the second surface 2S, and the wiring pattern 500 is disposed on the second bonding layer 220. The wiring pattern 500 is disposed on the bonding surface. The wiring pattern 500 may include a plurality of wiring patterns.

The wiring pattern 500 is connected to an external antenna pattern. Accordingly, the smart IC substrate can be driven in a contactless manner.

The wiring pattern 500 may include a wiring part 510 and a connection part 520.

The wiring part 510 may include a first wiring part 511, a second wiring part 512, and the third wiring part 513. The first wiring part 511 is disposed inside a molding region MA. The second wiring part 512 and the third wiring part 513 are disposed outside the molding region MA.

The first wiring part 511 and the third wiring part 513 may be connected by the second wiring part 512.

The first wiring part 511, the second wiring part 512, and the third wiring part 513 may have different line widths. For example, the line width of the second wiring part 512 may be greater than that of the first wiring part 511. Accordingly, after the molding part M is disposed inside the molding region MA, damage to the wiring part disposed outside the molding part M can be prevented.

The line width of the third wiring part 513 may be greater than that of the first wiring part 511 and the second wiring part 512. The third wiring part 513 is a region connected to a card body. Since the line width of the third wiring part 513 is formed large, the smart IC substrate and the card body can be easily connected.

The connection part 520 may include a first connection part 521 and a second connection part 522. Specifically, at least one wiring pattern among the plurality of wiring patterns may include the first connection part 521 and the second connection part 522.

Sizes of the first connection part 521 and the second connection part 522 may be smaller than the size of the hole H. In addition, the size of the second connection part 522 may be smaller than the size of the third wiring part 513. For example, an area of the second connection part 522 may be smaller than an area of the third wiring part 513. Accordingly, a space of the chip mounting region can be secured widely, and a packaging size can be reduced.

In addition, the first connection part 521 or the second connection part 522 is a region wire-bonded to the chip. The connection part includes two or more connection parts. Therefore, if a wire bonding problem occurs in one connection part, the problem can be resolved by wire bonding to another connection part. For example, if a wire bonding problem occurs in the first connection part 521, additional wire bonding can be performed to the second connection part 522.

The metal layer 300 is disposed on the substrate 100. The metal layer 300 includes a first metal layer 310 and a second metal layer 320. The first metal layer 310 is disposed on the first bonding layer 210. The second metal layer 320 is disposed on the second bonding layer 220.

The material and thickness of the metal layer 300 are the same as those of the first embodiment.

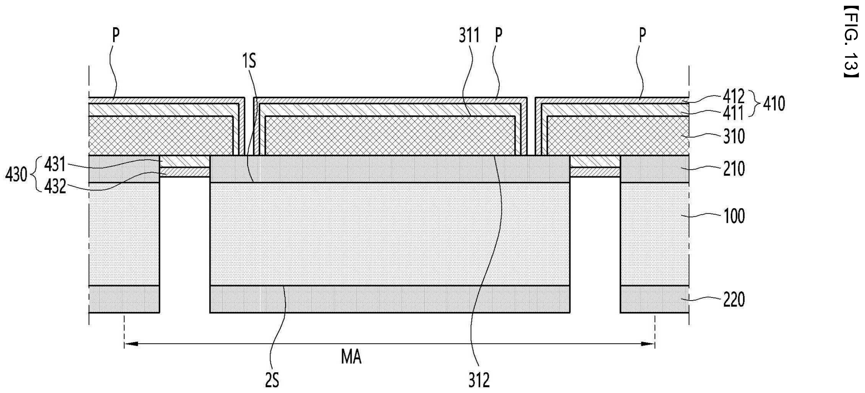

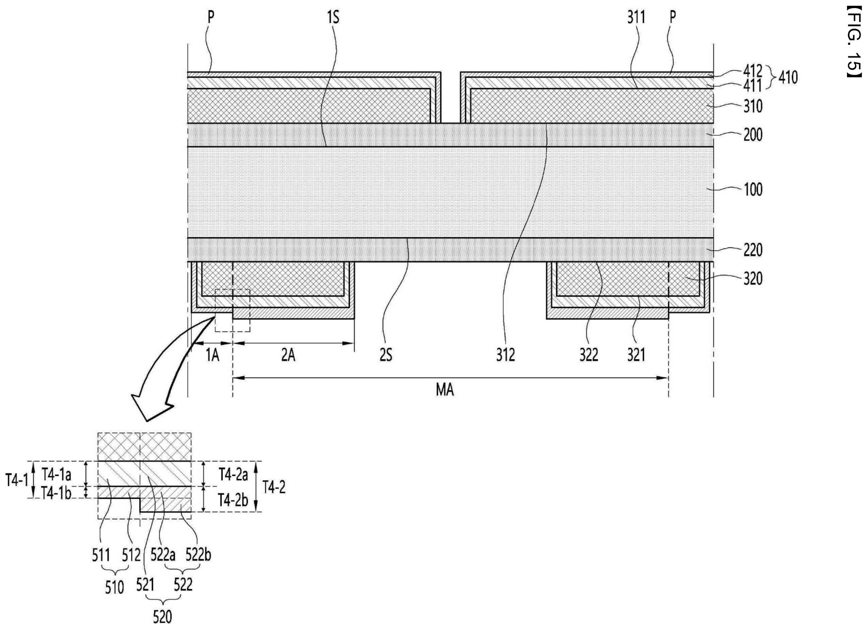

The plating layer is disposed on the metal layer 300. Referring to FIGS. 13 and 15, the plating layer is divided into multiple plating layers depending on their positions. Specifically, the plating layer may include a first plating layer 410, a third plating layer 430, and fourth plating layers 510 and 520 disposed at different positions.

The first plating layer 410 is disposed on one surface 311 of the first metal layer 310. The third plating layer 430 is disposed on the other surface 312 of the first metal layer 310. The third plating layer 430 is disposed in a region overlapping the hole H. The fourth plating layer 510 and 520 is disposed on one surface 321 of the second metal layer 320. The wiring pattern 500 is formed by the second metal layer 320 and the fourth plating layer 510 and 520.

The first plating layer 410 includes a first-first layer 411 and a first-second layer 412. The first-first layer 411 is disposed in contact with the first metal layer 310. The first-second layer 412 is disposed in contact with the first-first layer 411. Accordingly, the first-first layer 411 is disposed between the first metal layer 310 and the first-second layer 412.

The third plating layer 430 includes a third-first layer 431 and a third-second layer 432. The third-first layer 431 is disposed in contact with the first metal layer 310. The third-second layer 432 is disposed in contact with the third-first layer 431. Accordingly, the third-first layer 431 is disposed between the first metal layer 310 and the third-second layer 432.

The fourth plating layer includes a fourth-first plating layer 510 and a fourth-second plating layer 520. The fourth-first plating layer 510 and the fourth-second plating layer 520 are distinguished by their positions. Specifically, the fourth-first plating layer 510 and the fourth-second plating layer 520 are distinguished by a molding region MA. The fourth plating layer includes a first region 1A that does not overlap the molding region MA and a second region 2A that overlaps the molding region MA.

The fourth-first plating layer 510 is defined as a plating layer disposed on the outside of the molding region MA. That is, the fourth-first plating layer 510 is disposed in the first region 1A. The fourth-second plating layer 520 is defined as a plating layer disposed inside the molding region MA. That is, the fourth-second plating layer 520 is disposed in the second region 2A.

The fourth-first plating layer 510 includes a fourth-first-a layer 511 and a fourth-first-b layer 512. The fourth-first-a layer 511 is disposed in contact with the second metal layer 320. The fourth-first-b layer 512 is disposed in contact with the fourth-first-a layer 511. Accordingly, the fourth-first-a layer 511 is disposed between the second metal layer 320 and the fourth-first-b layer 512.

The fourth-second plating layer 520 includes a fourth-second-a layer 521 and a fourth-second-b layer 522. The fourth-second-a layer 521 is disposed in contact with the second metal layer 320. The fourth-second-b layer 522 is disposed in contact with the fourth-second-a layer 521. Accordingly, the fourth-second-a layer 521 is disposed between the second metal layer 320 and the fourth-second-b layer 522.

The fourth-first-a layer 511 and the fourth-second-a layer 521 are connected. Specifically, the fourth-first-a layer 511 and the fourth-second-a layer 521 are formed integrally. The fourth-first-b layer 512 and the fourth-second-b layer 522 are connected. In detail, the fourth-first-b layer 512 and the fourth-second-b layer 522 are formed integrally.

The fourth-first plating layer 510 and the fourth-second plating layer 520 may each include a side plating layer. In this case, the fourth-first plating layer 510 and the fourth-second plating layer 520 may include a side plating layer disposed in the molding region MA and a side plating layer disposed outside the molding region MA. A thickness of the side plating layer disposed in the molding region MA may be greater than a thickness of the side plating layer disposed outside the molding region MA. The first-first layer 411, the third-first layer 431, the fourth-first-a layer 511, and the fourth-second-a layer 521 may comprise the same material. In detail, the first-first layer 411, the third-first layer 431, the fourth-first-a layer 511, and the fourth-second-a layer 521 may include the same metal. For example, the first-first layer 411, the third-first layer 431, the fourth-first-a layer 511, and the fourth-second-a layer 521 may include nickel.

The first-second layer 412, the third-second layer 432, the fourth-first-b layer 512, and the fourth-second-b layer 522 may include the same material. In detail, the first-second layer 412, the third-second layer 432, the fourth-first-b layer 512, and the fourth-second-b layer 522 may include the same metal. For example, the first-second layer 412, the third-second layer 432, the fourth-first-b layer 512, and the fourth-second-b layer 522 may include gold (Au) or palladium (Pd).

The first plating layer 410, the third plating layer 430, the fourth-first plating layer 510, and the fourth-second plating layer 520 may have different sizes. Specifically, the thickness T1 of the first plating layer 410, the thickness T3 of the third plating layer 430, the thickness T4-1 of the fourth-first plating layer 510, and the thickness T4-2 of the fourth-second plating layer 520 may be different. Specifically, the thickness T1 of the first plating layer 410, the thickness T3 of the third plating layer 430, and the thickness T4-2 of the fourth-second plating layer 520 may be different. Specifically, the thickness T1 of the first plating layer 410, the thickness T3 of the third plating layer 430, and the thickness T4-1 of the fourth-first plating layer 510 may different. Specifically, the thickness T3 of the third plating layer 430 and the thickness T4-2 of the fourth-second plating layer 520 may be the same.

The thickness of the third plating layer 430 is greater than that of the first plating layer 410. The thickness of the third-first layer 431 and the thickness of the first-first layer 411 may be different. In detail, the thickness of the third-first layer 431 may be greater than the thickness of the first-first layer 411. In addition, the thickness of the third-second layer 432 is different from the thickness of the first-second layer 412. In detail, the thickness of the third-second layer 432 is greater than the thickness of the first-second layer 412. Accordingly, the thickness of the third plating layer 430 is greater than the thickness of the first plating layer 410.

The thickness T4-2 of the fourth-second plating layer 520 is greater than the thickness of the first plating layer 410. The thickness T4-2a of the fourth-second-a layer 521 may be different from the thickness of the first-first layer 411. In detail, the thickness T4-2a of the fourth-second-a layer 521 may be greater than the thickness of the first-first layer 411. In addition, the thickness T4-2b of the fourth-second-b layer 522 and the thickness of the first-second layer 412 are different. Specifically, the thickness T4-2b of the fourth-second-b layer 522 is greater than the thickness of the first-second layer 412. Accordingly, the thickness T4-2 of the fourth-first plating layer 520 is greater than the thickness T1 of the first plating layer 410.

The thickness T4-2 of the fourth-second plating layer 520 is greater than the thickness T4-1 of the fourth-first plating layer 510. The thickness T4-2a of the fourth-second-a layer 521 and the thickness T4-1a of the fourth-first-a layer 511 may be the same or similar. In addition, the thickness T4-2b of the fourth-second-b layer 522 and the thickness T4-1b of the fourth-first-b layer 512 are different. Specifically, the thickness T4-2b of the fourth-second-b layer 522 is greater than the thickness T4-1b of the fourth-first-b layer 512. Accordingly, the thickness T4-2 of the fourth-second plating layer 520 is greater than the thickness T4-1 of the fourth-first plating layer 510.

The thickness of the first-first layer 411 may be 1 µm to 3 µm. In addition, the thickness of the third-first layer 431, the thickness T4-1a of the fourth-first-a layer 511, and the thickness T4-2a of the fourth-second-a layer 521 may be 2 µm to 9 µm. The thickness of the third-first layer 431, the thickness T4-1a of the fourth-first-a layer 511, and the thickness T4-2a of the fourth-second-a layer 521 are greater than the thickness of the first-first layer 411 within the above range.

The third plating layer 430 and the fourth-second plating layer 520 are layers bonded to wires connected to the chip C. For this purpose, the third-second layer 432 and the fourth-second-b layer 522 are disposed to be thicker than that of the first-second layer 412. Therefore, since the third-first layer 431 and the fourth-second-a layer 521 must support the third-second layer 432 and the fourth-second-b layer 522, respectively, the thicknesses of the third-first layer 431 and the fourth-first-b layer 521 are greater than the thickness of the first-first layer 411 within the above range.

Furthermore, the fourth-first-a layer 511 and the fourth-second-a layer 521 may be formed using the same plating process for process efficiency. Therefore, the thickness T4-1a of the fourth-first-a layer 511 may be equal to or similar to the thickness T4-2a of the fourth-second-a layer 521.

The thickness of the first-second layer 412 may be 0.01 µm to 0.1 µm. The first plating layer 410 is disposed on the first surface 1S of the substrate 100. Therefore, the first plating layer 410 can be exposed to the outside of the smart IC card. Since the first-first layer 411 contains nickel, the first-first layer 411 has toxicity that is harmful to the human body. Therefore, the first-second layer 421 is disposed on the first-first layer 411. Accordingly, the first-first layer 411 is prevented from being exposed to the outside. In addition, the first-second layer 422 contains gold. Therefore, the aesthetic appeal of an external user is improved.

The thickness of the third-second layer 432 and the thickness T4-2b of the fourth-second-b layer 522 may be 0.2 µm to 0.8 µm, 0.2 µm to 0.7 µm, or 0.2 µm to 0.5 µm. The third plating layer 430 and the fourth-second plating layer 520 are bonded to a wire connected to the chip C. Therefore, the thickness of the third-second layer 432 and the thickness T4-2b of the fourth-second-b layer 522 are formed to be greater than the thicknesses of the first-second layer 412 and the fourth-first-b layer 512. If the thickness of the third-second layer 432 and the thickness T4-2b of the fourth-second-b layer 522 are less than 0.2 µm, the wire is not stably bonded. In addition, if the thickness of the third-second layer 432 and the thickness T4-2b of the fourth-second-b layer 522 exceed 0.8 µm, the process cost increases and the process efficiency decreases.

The thickness T4-1b of the fourth-first-b layer 512 may be 0.01 µm to 0.05 µm. The fourth-first plating layer 510 is not bonded to the wire. Therefore, the fourth-first-b layer 512 does not need to be formed as thick as the third-second layer 432 and the fourth-second-b layer 522. Accordingly, the thickness T4-1b of the fourth-first-b layer 512 is smaller than the thickness of the third-second layer 432 and the thickness T4-2b of the fourth-second-b layer 522.

Referring to FIG. 15, the fourth-second-b layer 522 may include a fourth-second-ba layer 522a and a fourth-second-bb layer 522b. The fourth-second-ba layer 522a is disposed in contact with the fourth-second-a layer 521. The fourth-second-bb layer 522b is disposed in contact with the fourth-second-ba layer 522a. Accordingly, the fourth-second-ba layer 522a is disposed between the fourth-second-a layer 521 and the fourth-second-bb layer 522b.

The fourth-first-a layer 511 and the fourth-second-a layer 521 are connected. Specifically, the fourth-a layer 511 and the fourth-second-a layer 521 are formed integrally. The fourth-first-b layer 512 and the fourth-second-ba layer 522a are connected. Specifically, the fourth-first-b layer 512 and the fourth-second-ba layer 522a are formed integrally. The fourth-second-bb layer 522b is formed on the fourth-second-ba layer 522a by selective plating.

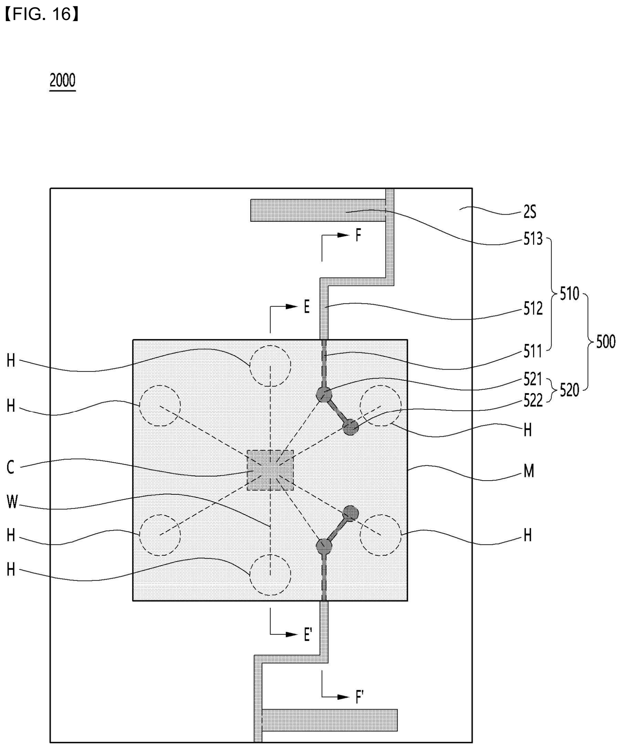

A smart IC module 2000 according to a second embodiment will now be described with reference to FIGS. 16 to 18. The smart IC module 2000 includes a smart IC substrate 1000, a chip C, and a molding member M according to the second embodiment described above.

The chip C is disposed on the second bonding layer 220.

The chip C is connected to the third plating layer 430. Specifically, the chip C and the third plating layer 430 are wire-bonded by a wire W. Accordingly, the chip C and the conductive patterns P are electrically connected.

The chip C is connected to the fourth-second plating layer 420. Specifically, the chip C and the fourth-second plating layer 420 are wire-bonded by the wire W. Accordingly, the chip C and the wiring pattern P are electrically connected. In addition, the chip C and an external antenna pattern are connected.

The molding part M includes a resin material. The molding part M is disposed on the chip C and the wire W. The molding part M protects the wire W and the chip C. Specifically, the molding part prevents external impact from being transmitted to the wire W. Accordingly, damage to the wire W can be prevented.

The smart IC substrate according to the second embodiment allows a thickness of the fourth-first plating layer to be smaller than that of the fourth-second plating layer. The fourth-first plating layer is not wire-bonded, so the fourth-first-b plating layer can have a smaller thickness.

Therefore, unnecessary plating processes are omitted, thereby improving process efficiency.

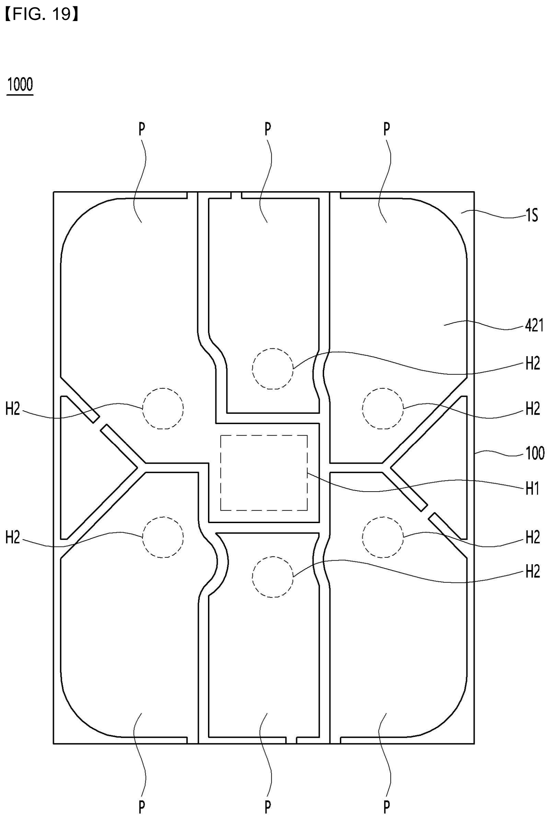

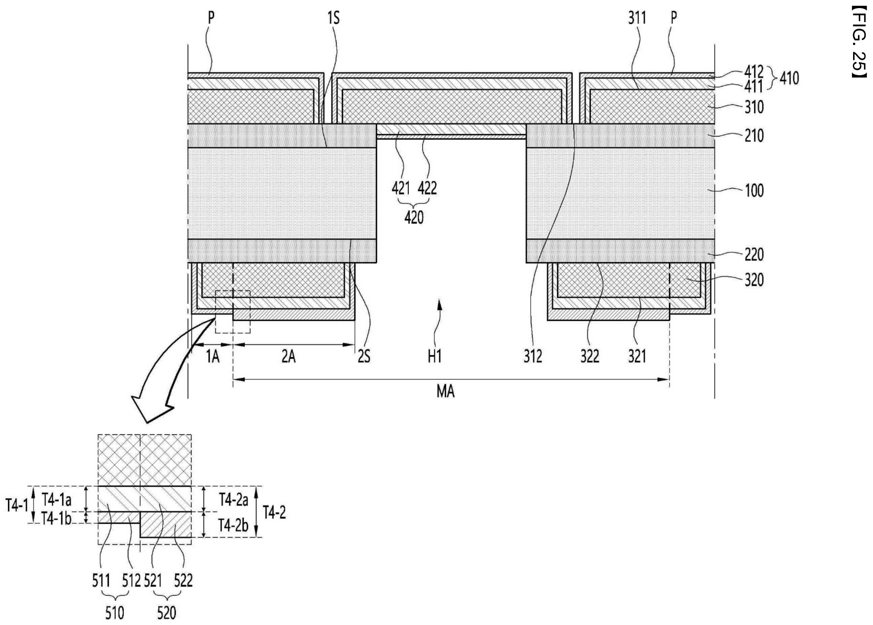

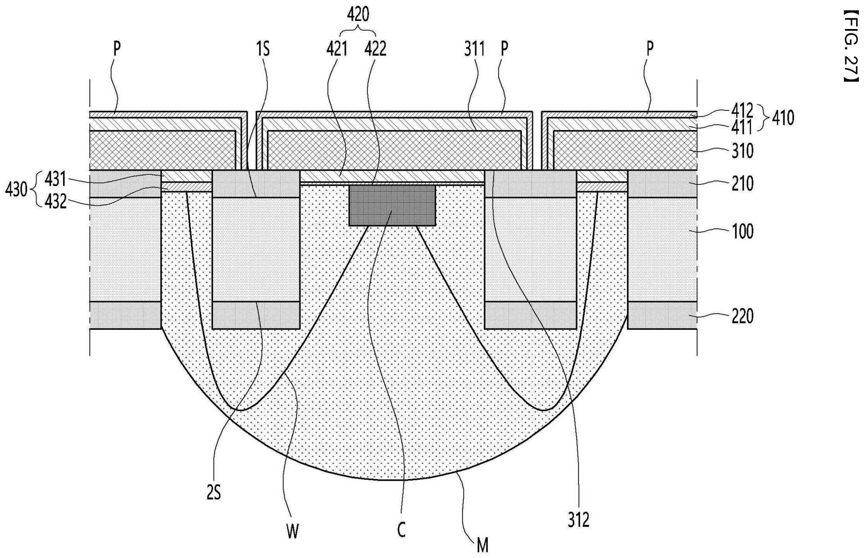

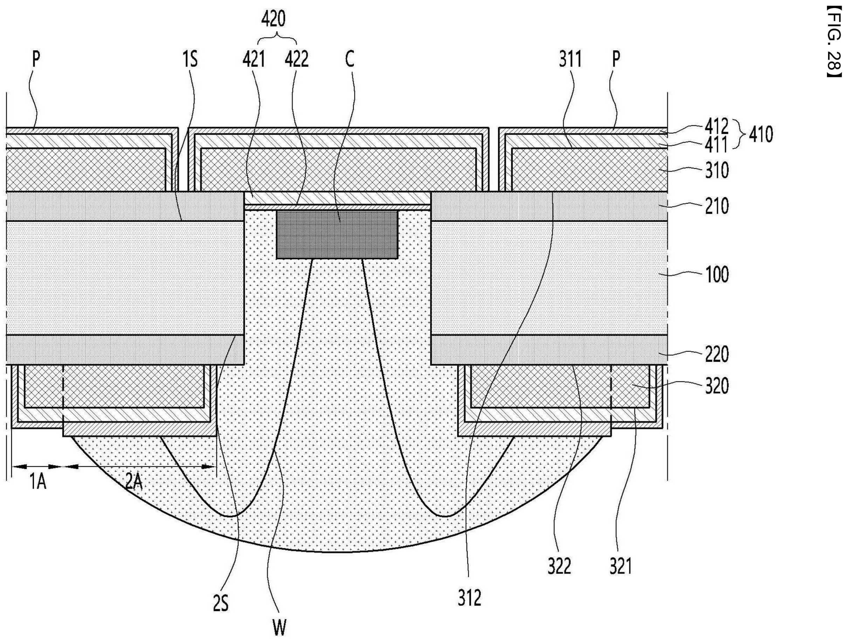

A smart IC substrate 1000 and a smart IC module 2000 according to the third embodiment will be described with reference to FIGS. 19 to 28. Descriptions of similar or identical elements to those of the first embodiment will be omitted. Furthermore, identical reference numerals are used for components identical to those of the first embodiment.

Referring to FIGS. 19 to 25, the smart IC substrate according to the third embodiment includes a substrate 100, a bonding layer 200, a metal layer 300, and a plating layer.

The substrate 100 includes a first surface 1S and a second surface 2S. The first surface 1S and the second surface 2S are opposite surfaces. The first surface 1S is defined as a contact surface. In addition, the second surface 2S is defined as a bonding surface.

The material, shape, and thickness of the substrate 100 are the same as those of the first embodiment.

The substrate 100 includes a hole. Specifically, the substrate 100 includes a first hole H1 and a second hole H2.

A size of the first hole H1 and a size of the second hole H2 are different. Specifically, the size of the first hole H1 is larger than the size of the second hole H2. A shape of the first hole H1 is different from a shape of the second hole H2. For example, the first hole H2 may be formed in a polygonal shape. Furthermore, the first hole H1 may be formed in a circular shape. The number of the first holes H1 is different from the number of the second holes H2. Specifically, the number of the first holes H1 is smaller than the number of the second holes H2.

The first hole H1 is a region where a chip C is disposed. The second hole H2 is a region where wire bonding performs. That is, the chip C disposed within the first hole H1 is wire bonded to the plating layer through the second hole H2.

The second hole H2 includes a plurality of holes. At least one of the plurality of holes is a region where wire bonding performs. For example, all of the plurality of holes are regions where wire bonding performs. Alternatively, some of the plurality of holes are regions where wire bonding performs.

The second hole H2 has a width within a set range. The width of the second hole H2 may be defined as the diameter of the second hole or the minimum distance between the inner surfaces of the second hole. For example, the width of the second hole H2 may be 500 µm to 1000 µm, 600 µm to 900 µm, or 700 µm to 800 µm. When the width of the second hole H2 is less than 500 µm, wire bonding through the second hole H2 becomes difficult. In addition, if the width of the second hole H2 exceeds 1000 µm, the support force of the substrate 100 decreases.

The bonding layer 200 is disposed on the substrate 100. Specifically, the bonding layer 200 includes a first bonding layer 210 and a second bonding layer 220. The first bonding layer 210 is disposed on the first surface 1S. The second bonding layer 220 is disposed on the second surface 2S.

The material and thickness of the bonding layer 200 are the same as those of the first embodiment.

The smart IC substrate 1000 includes a plurality of conductive patterns P and a wiring pattern 500. The conductive patterns P are disposed on the first surface 1S. The conductive patterns P are disposed on the first bonding layer 210. The conductive patterns P are disposed on the contact surface.

The conductive patterns P are disposed spaced apart from each other. The second hole H2 is disposed in a region corresponding to each conductive pattern P.

The wiring pattern 500 is disposed on the second surface 2S. The wiring pattern 500 is disposed on the second bonding layer 220. The wiring pattern 500 is disposed on the bonding surface.

The wiring pattern 500 is connected to an external antenna pattern. Accordingly, the smart IC substrate can be operated in a contactless manner.

The second wiring pattern 500 is the same as the second embodiment.

The metal layer 300 is disposed on the substrate 100. The metal layer 300 includes a first metal layer 310 and a second metal layer 320. The first metal layer 310 is disposed on the first bonding layer 210. The second metal layer 320 is disposed on the second bonding layer 220.

The material and thickness of the metal layer 300 are the same as those of the first embodiment.

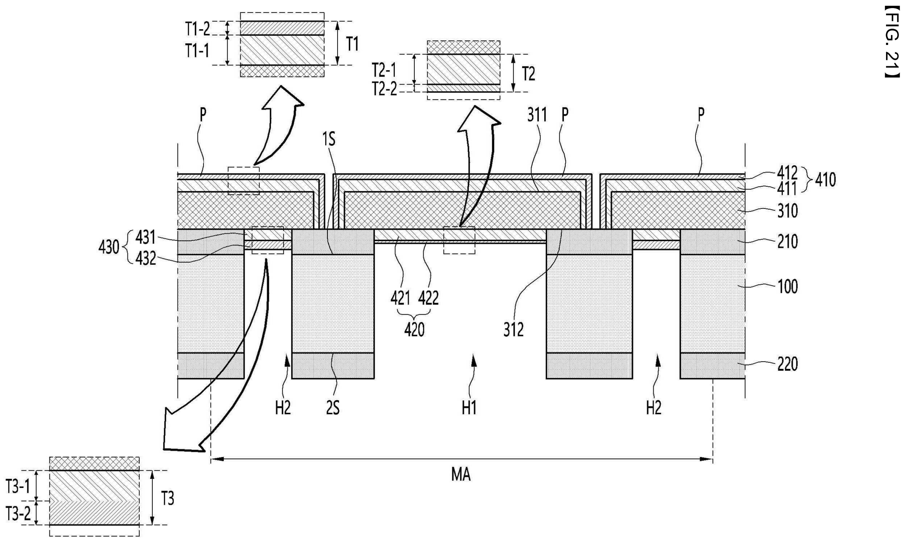

The plating layer is disposed on the metal layer 300. Referring to FIGS. 21 to 25, the plating layer is divided into multiple plating layers depending on their positions. Specifically, the plating layer may include a first plating layer 410, a second plating layer 420, a third plating layer 430, and fourth plating layers 510 and 520, which are disposed at different positions.

The first plating layer 410 is disposed on one surface 311 of the first metal layer 310. The second plating layer 420 is disposed on the other surface 312 of the first metal layer 310. The second plating layer 420 is disposed in a region overlapping the first hole H1. The third plating layer 430 is disposed on the other surface 312 of the first metal layer 310. The third plating layer 430 is disposed in a region overlapping the second hole H2. The fourth plating layers 510 and 520 are disposed on one surface 321 of the second metal layer 320. The wiring pattern 500 is formed by the second metal layer 320 and the fourth plating layers 510 and 520.

The first plating layer 410 includes a first-first layer 411 and a first-second layer 412. The first-first layer 411 is disposed in contact with the first metal layer 310. The first-second layer 412 is disposed in contact with the first-first layer 411. Accordingly, the first-first layer 411 is disposed between the first metal layer 310 and the first-second layer 412.

The second plating layer 420 includes a second-first layer 421 and a second-second layer 422. The second-first layer 421 is disposed in contact with the first metal layer 310. The second-second layer 422 is disposed in contact with the second-first layer 421. Accordingly, the second-first layer 421 is disposed between the first metal layer 310 and the second-second layer 422.

The third plating layer 430 includes a third-first layer 431 and a third-second layer 432. The third-first layer 431 is disposed in contact with the first metal layer 310. The third-second layer 432 is disposed in contact with the third-first layer 431. Accordingly, the third-first layer 431 is disposed between the first metal layer 310 and the third-second layer 432.

The fourth plating layer includes a fourth-first plating layer 510 and a fourth-second plating layer 520. The fourth-first plating layer 510 and the fourth-second plating layer 520 are distinguished by their positions. Specifically, the fourth-first plating layer 510 and the fourth-second plating layer 520 are distinguished by a molding region MA. The fourth plating layer includes a first region 1A that does not overlap the molding region MA and a second region 2A that overlaps the molding region MA.

The fourth-first plating layer 510 is defined as a plating layer disposed outside the molding region MA. That is, the fourth-first plating layer 510 is disposed in the first region 1A. The fourth-second plating layer 520 is defined as a plating layer disposed inside the molding region MA. That is, the fourth-second plating layer 520 is disposed in the second region 2A.

The fourth-first plating layer 510 includes a fourth-first-a layer 511 and a fourth-first-b layer 512. The fourth-first-a layer 511 is disposed in contact with the second metal layer 320. The fourth-first-b layer 512 is disposed in contact with the fourth-first-a layer 511. Accordingly, the fourth-first-a layer 511 is disposed between the second metal layer 320 and the fourth-first-b layer 512.

The fourth-second plating layer 520 includes a fourth-second-a layer 521 and a fourth-second-b layer 522. The fourth-second-a layer 521 is disposed in contact with the second metal layer 320. The fourth-second-b layer 522 is disposed in contact with the fourth-second-a layer 521. Accordingly, the fourth-second-a layer 521 is disposed between the second metal layer 320 and the fourth-second-b layer 522.

The fourth-first-a layer 511 and the fourth-second-a layer 521 are connected. Specifically, the fourth-first-a layer 511 and the fourth-second-a layer 521 are formed integrally. The fourth-first-b layer 512 and the fourth-second-b layer 522 are connected. Specifically, the fourth-first-b layer 512 and the fourth-second-b layer 522 are formed integrally.

The first-first layer 411, the second-first layer 421, the third-first layer 431, the fourth-first-a layer 511, and the fourth-second-a layer 521 may comprise the same material. Specifically, the first-first layer 411, the second-first layer 421, the third-first layer 431, the fourth-first-a layer 511, and the fourth-second-a layer 521 may comprise the same metal. For example, the first-first layer 411, the second-first layer 421, the third-first layer 431, the fourth-first-a layer 511, and the fourth-second-a layer 521 may comprise nickel.

The first-second layer 412, the second-second layer 422, the third-second layer 432, the fourth-first-b layer 512, and the fourth-second-b layer 522 may include the same material. In detail, the first-second layer 412, the second-second layer 422, the third-second layer 432, the fourth-first-b layer 512, and the fourth-second-b layer 522 may include the same metal. For example, the first-second layer 412, the second-second layer 422, the third-second layer 432, the fourth-first-b layer 512, and the fourth-second-b layer 522 may include gold (Au) or palladium (Pd).

The first plating layer 410, the second plating layer 420, the third plating layer 430, the fourth-first plating layer 510, and the fourth-second plating layer 520 may have different sizes. Specifically, the thickness T1 of the first plating layer 410, the thickness T2 of the second plating layer 420, the thickness T3 of the third plating layer 430, the thickness T4-1 of the fourth-first plating layer 510, and the thickness T4-2 of the fourth-second plating layer 520 may be different.

The thickness T3 of the third plating layer 430 is greater than the thickness T1 of the first plating layer 410. The thickness T3-1 of the third-first layer 431 may differ from the thickness T1-1 of the first-first layer 411. In detail, the thickness T3-1 of the third-first layer 431 may be greater than the thickness T1-1 of the first-first layer 411. In addition, the thickness T3-2 of the third-second layer 432 and the thickness T1-2 of the first-second layer 412 are different. In detail, the thickness T3-2 of the third-second layer 432 is greater than the thickness T1-2 of the first-second layer 412. Accordingly, the thickness T3 of the third plating layer 430 is greater than the thickness T1 of the first plating layer 410.

The thickness T3 of the third plating layer 430 is greater than the thickness T2 of the second plating layer 420. In detail, the thickness T3-1 of the third-first layer 431 and the thickness T2-1 of the second-first layer 421 are the same or similar. In addition, the thickness T3-2 of the third-second layer 432 and the thickness T2-2 of the second-second layer 422 are different. In detail, the thickness T3-2 of the third-second layer 432 is greater than the thickness T2-2 of the second-second layer 422. Accordingly, the thickness T3 of the third plating layer 430 is greater than the thickness T2 of the second plating layer 420.

The thickness T2 of the second plating layer 420 is greater than the thickness T1 of the first plating layer 410. The thickness T2-1 of the second-first layer 421 and the thickness T1-1 of the first-first layer 411 may be different. Specifically, the thickness T2-1 of the second-first layer 421 may be greater than the thickness T1-1 of the first-first layer 411. In addition, the thickness T1-2 of the first-second layer 412 and the thickness T2-2 of the second-second layer 422 are the same or similar. Accordingly, the thickness T2 of the second plating layer 420 is greater than the thickness T1 of the first plating layer 410.

The thickness T4-2 of the fourth-second plating layer 520 is greater than the thickness T1 of the first plating layer 410. The thickness T4-2a of the fourth-second-a layer 521 and the thickness T1-1 of the first-first layer 411 may be different. Specifically, the thickness T4-1b of the fourth-second-a layer 521 may be greater than the thickness T1-1 of the first-first layer 411. In addition, the thickness T4-2b of the fourth-second-b layer 522 and the thickness T1-2 of the first-second layer 412 are different. Specifically, the thickness T4-2b of the fourth-second-b layer 522 is greater than the thickness T1-2 of the first-second layer 412. Accordingly, the thickness T4-2 of the fourth-first plating layer 520 is greater than the thickness T1 of the first plating layer 410.

The thickness T4-2 of the fourth-second plating layer 520 is greater than the thickness T4-1 of the fourth-first plating layer 510. The thickness T4-2a of the fourth-second-a layer 521 and the thickness T4-1a of the fourth-first-a layer 511 may be the same or similar. In addition, the thickness T4-2b of the fourth-second-b layer 522 and the thickness T4-1b of the fourth-first-b layer 512 are different. Specifically, the thickness T4-2b of the fourth-second-b layer 522 is greater than the thickness T4-1b of the fourth-first-b layer 512. Accordingly, the thickness T4-2 of the fourth-second plating layer 520 is greater than the thickness T4-1 of the fourth-first plating layer 510.

The thickness T1-1 of the first-first layer 411 may be 1 µm to 3 µm. In addition, the thickness T2-1 of the second-first layer 421, the thickness T3-1 of the third-first layer 431, the thickness T4-1a of the fourth-first-a layer 511, and the thickness T4-2a of the fourth-second-a layer 521 may be 2 µm to 9 µm. The thickness T2-1 of the second-first layer 421, the thickness T3-1 of the third-first layer 431, the thickness T4-1a of the fourth-first-a layer 511, and the thickness T4-2a of the fourth-second-a layer 521 are greater than the thickness T1-1 of the first-first layer 411 within the above range.

The third plating layer 430 and the fourth-second plating layer 520 are layers that are bonded to the wires connected to the chip C. For this purpose, the third-second layer 432 and the fourth-second-b layer 522 are disposed thicker than the first-second layer 412. Therefore, since the third-first layer 431 and the fourth-second-a layer 521 must support the third-second layer 432 and the fourth-second-b layer 522, respectively, the thickness T3-1 of the third-first layer 431 and the fourth-second-a layer 521 are greater than the thickness T1-1 of the first-first layer 411 within the above range.

In addition, the second-first layer 421, the third-first layer 431, the fourth-first-a layer 511, and the fourth-second-a layer 521 may be formed by the same plating process for process efficiency. Therefore, the thicknesses of the second-first layer 421, the third-first layer 431, the fourth-first-a layer 511, and the fourth-second-a layer 521 may be the same or similar.

The thickness T1-2 of the first-second layer 412 may be 0.01 µm to 0.1 µm. The first plating layer 410 is disposed on the first surface 1S of the substrate 100. Therefore, the first plating layer 410 may be exposed to the outside of the smart IC card. Since the first-first layer 411 includes nickel, the first-first layer 411 has toxicity that is harmful to the human body. Accordingly, the first-second layer 421 is disposed on the first-first layer 411. This prevents the first-first layer 411 from being exposed to the outside. In addition, the first-second layer 422 includes gold. Therefore, it improves the aesthetic appeal of external users.

The thickness T3-2 of the third-second layer 432 and the thickness T4-2b of the fourth-second-b layer 522 may be 0.2 µm to 0.8 µm, 0.2 µm to 0.7 µm, or 0.2 µm to 0.5 µm. The third plating layer 430 and the fourth-second plating layer 520 are bonded to wires connected to the chip C. Accordingly, the thickness T3-2 of the third-second layer 432 and the thickness T4-2b of the fourth-second-b layer 522 are formed to be greater than the thicknesses of the first-second layer 412 and the fourth-first-b layer 512. If the thickness T3-2 of the third-second layer 432 and the thickness T4-2b of the fourth-second-b layer 522 are less than 0.2 µm, the wire is not stably bonded. In addition, if the thickness T3-2 of the third-second layer 432 and the thickness T4-2b of the fourth-second-b layer 522 exceed 0.8 µm, the process cost increases and the process efficiency decreases.

The thickness T2-2 of the second-second layer 422 and the thickness T4-1b of the fourth-first-b layer 512 may be 0.01 µm to 0.05 µm. The second plating layer 420 and the fourth-first plating layer 510 are not bonded to the wire. Therefore, the second-second layer 422 and the fourth-first-b layer 512 do not need to be formed as thick as the third-second layer 432 and the fourth-second-b layer 522. Accordingly, the thickness T4-1b of the third-second layer 432 and the fourth-first-b layer 512 is smaller than the thickness T3-2 of the third-second layer 432 and the thickness T4-2b of the fourth-second-b layer 522.

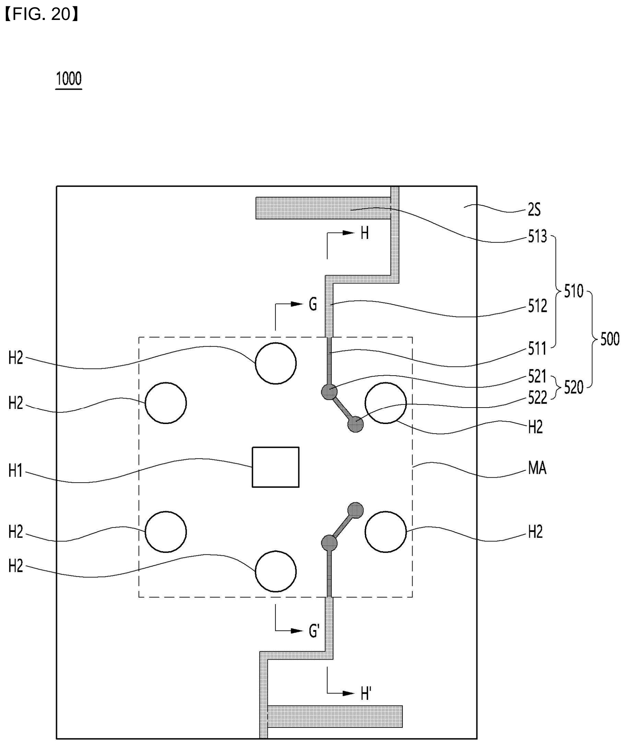

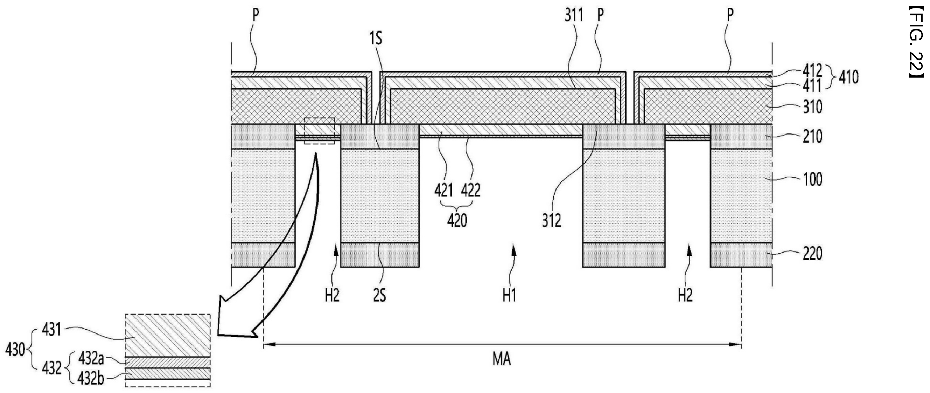

Referring to FIG. 22, the third-second layer 432 may include a plurality of layers. The third-second layer 432 may include a third-second-a layer 432a and a third-second-b layer 432b. The third-second-a layer 432a is disposed on the third-first layer 431. The third-second-a layer 432a is in contact with the third-first layer 431. The third-second-b layer 432b is disposed on the third-second-a layer 432a. The third-second-b layer 432b is in contact with the third-second-a layer 432a. The description of FIG. 20 is identical to that of FIG. 4. Therefore, the following description is omitted.

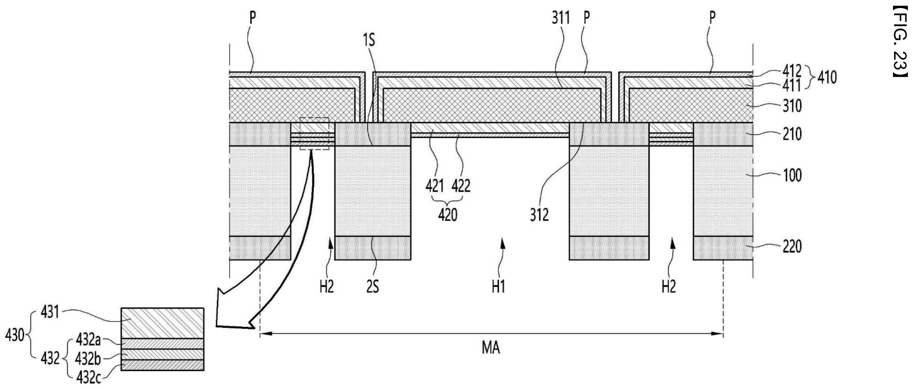

Referring to FIG. 23, the third-second layer 432 may include a plurality of layers. The third-second layer 432 may include a third-second-a layer 432a, a third-second-b layer 432b, and a third-second-c layer 432c. The third-second-a layer 432a is disposed on the third-first layer 431. The third-second-a layer 432a is in contact with the third-first layer 431. The third-second-b layer 432b is disposed on the third-second-a layer 432a. The third-second-b layer 432b is in contact with the third-second-a layer 432a. The third-second-c layer 432c is disposed on the third-second-b layer 432b. The third-second-c layer 432c is in contact with the third-second-b layer 432b. The description of FIG. 21 is identical to that of FIG. 5. Therefore, the following description is omitted.

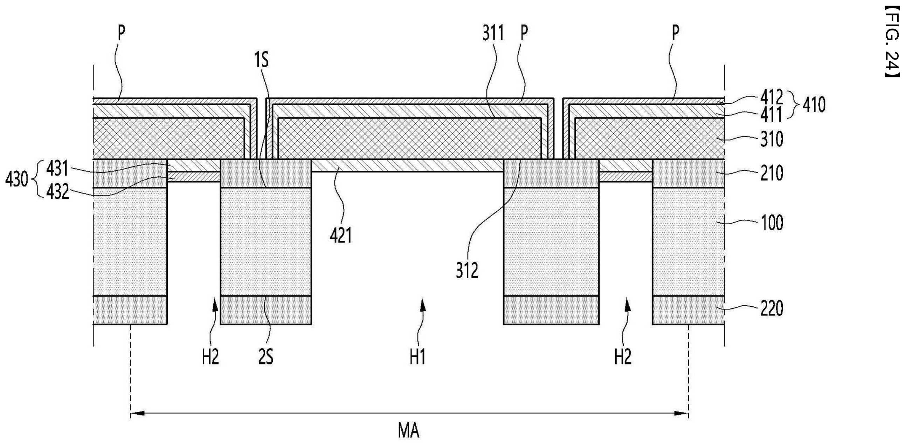

Referring to FIG. 24, the second plating layer 420 may not include the second-second layer 422. That is, the second plating layer 420 may only include the second-first layer 421. For example, both the first-second layer 412 and the third-second layer 432 may be formed through selective plating. Accordingly, the second-second layer 422 is not formed on the second plating layer 420. Consequently, unnecessary plating processes are omitted, thereby improving process efficiency.

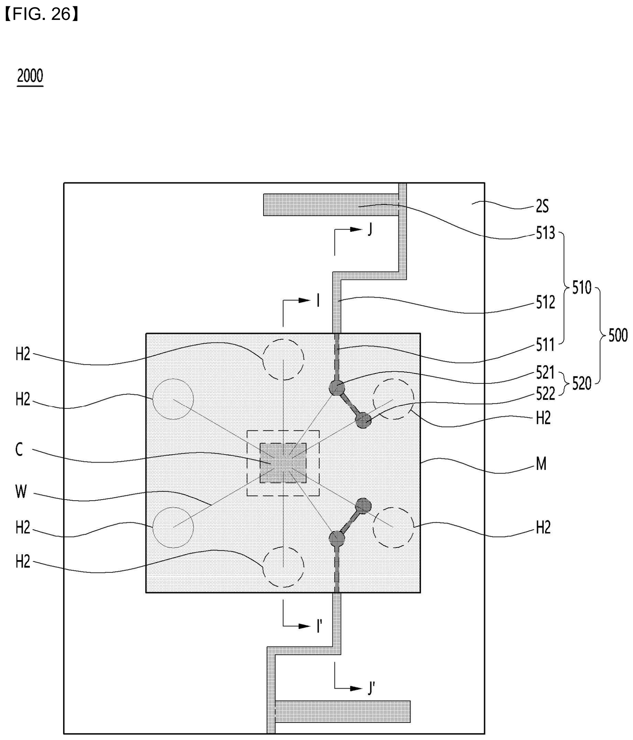

A smart IC module 2000 according to a third embodiment will now be described with reference to FIGS. 26 to 28. The smart IC module 2000 includes a smart IC substrate 1000, a chip C, and a molding part M according to the third embodiment described above.

The chip C is disposed on the other surface 312 of the first metal layer 300. The chip C is disposed within the first hole H1. Accordingly, the thickness of the smart IC module 2000 can be reduced.

The chip C is connected to the third plating layer 430. Specifically, the chip C and the third plating layer 430 are wire-bonded by a wire W. Accordingly, the chip C and the conductive patterns P are electrically connected.

The chip C is connected to the fourth-second plating layer 520. Specifically, the chip C and the fourth-second plating layer 520 are wire-bonded by the wire W. Accordingly, the chip C and the wiring pattern P are electrically connected. In addition, the chip C and an external antenna pattern are connected.

The molding part M comprises a resin material. The molding part M is disposed on the chip C and the wire W. The molding part M protects the wire W and the chip C. Specifically, the molding part prevents external impact from being transmitted to the wire W. This prevents damage to the wire W.

In a smart IC substrate according to a third embodiment, the chip C is disposed within the first hole H1. This reduces the thickness of the smart IC module.

In a smart IC substrate according to a third embodiment, the fourth-first plating layer is formed to a thickness less than the fourth-second plating layer. The fourth-first plating layer is not wire-bonded, so the fourth-first-b plating layer can be formed to a smaller thickness.

Therefore, unnecessary plating processes are omitted, thereby improving process efficiency.

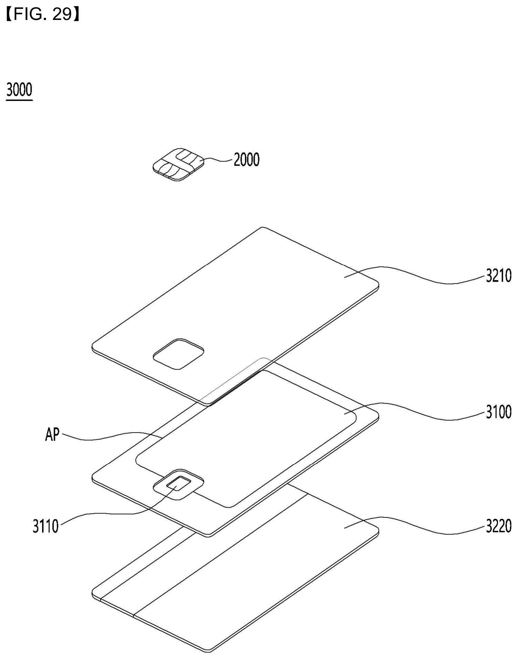

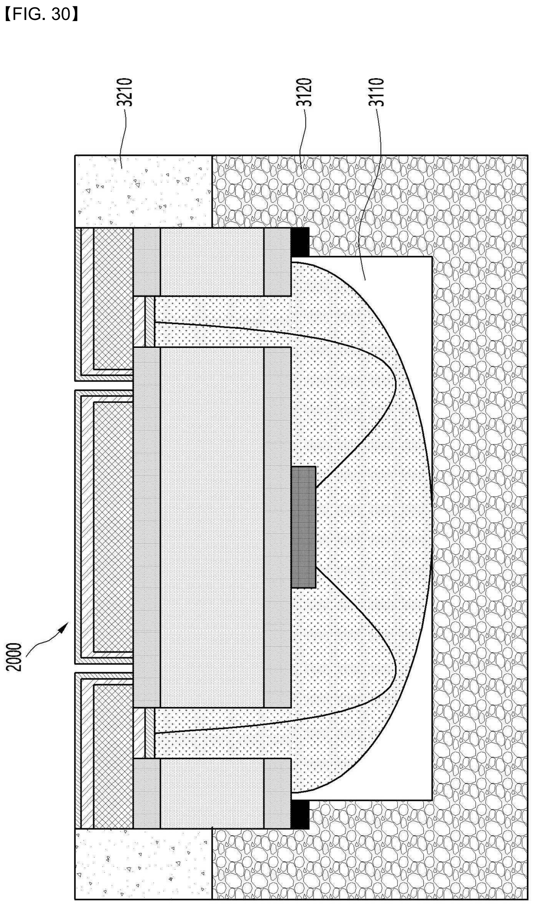

Hereinafter, a smart IC card according to an embodiment will be described with reference to FIGS. 29 and 30.

Referring to FIGS. 29 and 30, the smart IC card 3000 may include a main body 3100, a first protective layer 3210, and a second protective layer 3220.

The main body 3100 includes a receiving portion 3110. The smart IC module 2000 is disposed within the receiving portion 3110.

An antenna pattern AP may be disposed on the main body 3100. Specifically, the antenna pattern AP may be disposed in a coil shape at an edge of the main body 3100.

The smart IC module according to the first embodiment, which does not include the wiring pattern 500, does not have the antenna pattern AP disposed on the main body 3100. Accordingly, the IC card including the smart IC module according to the first embodiment operates as a contact card.

In addition, the smart IC module according to the second and third embodiments including the wiring pattern 500 has the antenna pattern AP disposed on the main body 3100. The wiring pattern 500 is connected to the antenna pattern AP. Accordingly, the IC card including the smart IC module according to the second and third embodiments operates as a contactless card, a combination card, or a hybrid card.

The smart IC module 2000 is inserted into the receiving portion 3110. The smart IC module 2000 and the main body 3100 are bonded by an adhesive layer 3120. As a result, the smart IC module 2000 is inserted into and fixed in the receiving portion 3110.

The first protective layer 3210 is disposed on the upper portion of the main body 3100. The first protective layer 3210 may include a transparent material. The first protective layer 3210 may include a transparent resin material. The first protective layer 3210 may be disposed in at least one layer. That is, the first protective layer 3210 may include a plurality of layers.

The second protective layer 3220 is disposed on the lower portion of the main body 3100. A magnetic stripe may be disposed on the second protective layer 3220. The second protective layer 3220 may include a transparent material. The second protective layer 3220 may include a transparent resin material. The second protective layer 3220 may be disposed in at least one layer. That is, the second protective layer 3220 may include a plurality of layers.

The characteristics, structures and effects described in the embodiments above are included in at least one embodiment but are not limited to one embodiment. In addition, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A smart IC substrate comprising:
a substrate including a first surface and a second surface opposite the first surface, and having first and second holes passing through the first surface and the second surface and spaced apart from each other in a horizontal direction;
a bonding layer disposed on the first surface;
a metal layer disposed on the bonding layer;
a first plating layer disposed on one surface of the metal layer;
a second plating layer and a third plating layer disposed on another surface of the metal layer,
wherein the second plating layer overlaps the first hole,
wherein the third plating layer overlaps the second hole, and
wherein the third plating layer has a thickness greater than that of the second plating layer.

2. The smart IC substrate of claim 1, wherein the first plating layer includes a first-first layer and a first-second layer on the first-first layer,
wherein the second plating layer includes a second-first layer and a second-second layer on the second-first layer,
wherein the third plating layer includes a third-first layer and a third-second layer on the third-first layer, and
wherein the third-second layer has a thickness greater than that of the second-second layer.

3. The smart IC substrate of claim 2, wherein thicknesses of the second plating layer and the third plating layer are greater than that of the first plating layer.

4. The smart IC substrate of claim 3, wherein thicknesses of the second-first layer and the third-first layer are greater than that of the first-first layer.

5. The smart IC substrate of claim 2, wherein
the third-second layer includes a third-second-a layer and a third-second-b layer on the third-second-a layer, and
wherein the third-second-b layer has a thickness greater than that of the third-second-a layer.

6. The smart IC substrate of claim 2, wherein the third-second layer includes a third-second-a layer, a third-second-b layer on the third-second-a layer, and a third-second-c layer on the third-second-b layer, and
wherein any one of the third-second-a layer, the third-second-b layer, and the third-second-c layer includes a material different from that of the other layers.

7. The smart IC substrate of claim 6, wherein the third-second-b layer has a thickness greater than that of the third-second-a layer and the third-second-c layer,
wherein the third-second-a layer and the third-second-c layer include gold, and
wherein the third-second-b layer include silver.

8. A smart IC substrate comprising:
a substrate including a plurality of holes, and a first surface and a second surface opposite the first surface;
a first bonding layer disposed on the first surface;
a second bonding layer disposed on the second surface;
a first metal layer disposed on the first bonding layer;
a second metal layer disposed on the second bonding layer;
a first plating layer disposed on one surface of the first metal layer;
a third plating layer disposed on another surface of the first metal layer; and
a fourth plating layer disposed on one surface of the second metal layer,
wherein the fourth plating layer includes a fourth-first plating layer and a fourth-second plating layer,
wherein the third plating layer overlaps the hole,
wherein the fourth-first plating layer is disposed outside a molding region,
wherein the fourth-second plating layer is disposed inside the molding region, and
wherein a thickness of the fourth-second plating layer is greater than a thickness of the fourth-first plating layer.

9. The smart IC substrate of claim 8, wherein the third plating layer and the fourth-second plating layer have thicknesses greater than those of the first plating layer,

10. The smart IC substrate of claim 8, wherein the first plating layer includes a first-first layer and a first-second layer on the first-first layer,
wherein the third plating layer includes a third-first layer and a third-second layer on the third-first layer,
wherein the fourth-first plating layer includes a fourth-first-a layer and a fourth-first-b layer on the fourth-first-a layer,
wherein the fourth-second plating layer includes a fourth-second-a layer and a fourth-second-b layer on the fourth-second-a layer, and
wherein the fourth-second-b layer has a thickness greater than that of the fourth-first-b layer.
